(19) Europäisches Patentamt / European Patent Office / Office européen des brevets

(11) **EP 4 036 617 A1**

(12) **EUROPEAN PATENT APPLICATION**
published in accordance with Art. 153(4) EPC

(43) Date of publication:
**03.08.2022 Bulletin 2022/31**

(21) Application number: **20868258.3**

(22) Date of filing: **16.09.2020**

(51) International Patent Classification (IPC):
**G02B 5/20** (2006.01)        **H01L 27/146** (2006.01)
**H04N 9/07** (2006.01)

(52) Cooperative Patent Classification (CPC):
**G02B 5/20; H01L 27/146; H04N 9/07**

(86) International application number:
**PCT/JP2020/035144**

(87) International publication number:
**WO 2021/060118 (01.04.2021 Gazette 2021/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.09.2019 JP 2019175596**

(71) Applicant: **Sony Semiconductor Solutions
Corporation
Atsugi-shi Kanagawa 243-0014 (JP)**

(72) Inventor: **SATO, Yasushi
Atsugi-shi, Kanagawa 243-0014 (JP)**

(74) Representative: **Müller Hoffmann & Partner
Patentanwälte mbB
St.-Martin-Strasse 58
81541 München (DE)**

(54) **IMAGING DEVICE**

(57)    Provided is an imaging device (1) capable of improving quality of an image captured using a color filter. An imaging device according to an embodiment includes a pixel array (110) including a plurality of pixel blocks (130) each including 6 × 6 pixels, and each pixel block includes a first pixel on which a first optical filter that transmits light in a first wavelength range is provided, a second pixel on which a second optical filter that transmits light in a second wavelength range is provided, a third pixel on which a third optical filter that transmits light in a third wavelength range is provided, and a fourth pixel on which a fourth optical filter that transmits light in a fourth wavelength range is provided. The first pixels are alternately arranged in each of a row direction and a column direction of the arrangement, one second pixel, one third pixel, and one fourth pixels are alternately arranged in each row and each column of the arrangement, and the pixel block further includes a line including at least one second pixel, one third pixel, and one fourth pixel in a first oblique direction that is parallel to a diagonal of the pixel block of the arrangement, and a line including at least one second pixel, one third pixel, and one fourth pixel in a second oblique direction that is parallel to a diagonal of the pixel block and is different from the first oblique direction.

FIG.6A

**Description**

Field

The present disclosure relates to an imaging device.

Background

A two-dimensional image sensor using each of a red (R) color filter, a green (G) color filter, and a blue (B) color filter, and a filter (referred to as a white (W) color filter) that transmits light in substantially the entire visible light range has been known.
In this two-dimensional image sensor, for example, with a pixel block of 4 × 4 pixels as a unit, eight pixels on which the W color filters are provided are arranged alternately in vertical and horizontal directions of the block. Furthermore, two pixels on which the R color filters are provided, two pixels on which the B color filters are provided, and four pixels on which the G color filters are provided are arranged so that the pixels on which the color filters of the same color are provided are not adjacent to each other in an oblique direction.
Such a two-dimensional image sensor using each of the R color filter, the G color filter, and the B color filter, and the W color filter can obtain a full-color image on the basis of the light transmitted through each of the R color filter, the G color filter, and the B color filter, and can obtain high sensitivity on the basis of the light transmitted through the W color filter. In addition, such a two-dimensional image sensor is expected to be used as a monitoring camera or an in-vehicle camera because a visible image and an infrared (IR) image can be separated by signal processing.

Citation List

Patent Literature

Patent Literature 1: WO 13/145487 A
Patent Literature 2: JP 6530751 B2

Summary

Technical Problem

In the above-described two-dimensional image sensor according to an existing technology in which each of the R color filter, the G color filter, the B color filter, and the W color filter is provided and the respective pixels are arranged in an arrangement of 4 × 4 pixels, color artifacts (false colors) are likely to occur, and it is difficult to obtain a high-quality image.
An object of the present disclosure is to provide an imaging device capable of improving quality of an image captured using a color filter.

Solution to Problem

For solving the problem described above, an imaging device according to one aspect of the present disclosure has a pixel array that includes pixels arranged in a matrix arrangement, wherein the pixel array includes a plurality of pixel blocks each including 6 × 6 pixels, the pixel block includes: a first pixel on which a first optical filter that transmits light in a first wavelength range is provided; a second pixel on which a second optical filter that transmits light in a second wavelength range is provided; a third pixel on which a third optical filter that transmits light in a third wavelength range is provided; and a fourth pixel on which a fourth optical filter that transmits light in a fourth wavelength range is provided, the first pixels are alternately arranged in each of a row direction and a column direction of the arrangement, one second pixel, one third pixel, and one fourth pixels are alternately arranged in each row and each column of the arrangement, and the pixel block further includes a line including at least one second pixel, one third pixel, and one fourth pixel in a first oblique direction that is parallel to a diagonal of the pixel block of the arrangement, and a line including at least one second pixel, one third pixel, and one fourth pixel in a second oblique direction that is parallel to a diagonal of the pixel block and is different from the first oblique direction.

Brief Description of Drawings

FIG. 1 is a functional block diagram of an example for describing functions of an imaging device applicable to a first embodiment.

FIG. 2 is a block diagram illustrating a configuration of an example of an imaging unit applicable to each embodiment.

FIG. 3 is a block diagram illustrating an example of a hardware configuration of the imaging device applicable to the first embodiment.

FIG. 4 is a schematic diagram illustrating an example of a pixel arrangement using each of an R color filter, a G color filter, a B color filter, and a W color filter according to an existing technology.

FIG. 5 is a diagram illustrating an example of a captured image obtained by capturing an image of a circular zone plate (CZP) using an imaging device in which a pixel array has the pixel arrangement according to the existing technology.

FIG. 6A is a schematic diagram illustrating an example of a pixel arrangement applicable to the first embodiment.

FIG. 6B is a schematic diagram illustrating the example of the pixel arrangement applicable to the first embodiment.

FIG. 7A is a schematic diagram for describing two series for performing synchronization processing according to the first embodiment.

FIG. 7B is a schematic diagram for describing two series for performing the synchronization processing according to the first embodiment.

FIG. 8A is a schematic diagram illustrating an extracted A-series pixel group.

FIG. 8B is a schematic diagram illustrating an extracted D-series pixel group.

FIG. 9 is a functional block diagram of an example for describing functions of an image processing unit applicable to the first embodiment.

FIG. 10 is a schematic diagram for describing effects of the pixel arrangement and signal processing according to the first embodiment.

FIG. 11A is a schematic diagram illustrating another example of the pixel arrangement applicable to the present disclosure.

FIG. 11B is a schematic diagram illustrating another example of the pixel arrangement applicable to the present disclosure.

FIG. 11C is a schematic diagram illustrating another example of the pixel arrangement applicable to the present disclosure.

FIG. 12 is a functional block diagram of an example for describing functions of an imaging device applicable to a second embodiment.

FIG. 13 is a diagram illustrating an example of a transmission characteristic of a dual bandpass filter applicable to the second embodiment.

FIG. 14 is a functional block diagram of an example for describing functions of an image processing unit applicable to the second embodiment.

FIG. 15 is a functional block diagram of an example for describing functions of an infrared (IR) separation processing unit applicable to the second embodiment.

FIG. 16 is a functional block diagram of an example for describing functions of an infrared light component generation unit applicable to the second embodiment.

FIG. 17 is a functional block diagram of an example for describing functions of a visible light component generation unit applicable to the second embodiment.

FIG. 18A is a functional block diagram of an example for describing functions of a saturated pixel detection unit applicable to the second embodiment.

FIG. 18B is a schematic diagram illustrating an example of setting of a value of a coefficient $\alpha$ for each signal level applicable to the second embodiment.

FIG. 19 is a schematic diagram illustrating an example of a sensitivity characteristic of each of pixels R, G, B, and W applicable to the second embodiment.

FIG. 20 is a schematic diagram illustrating an example of the sensitivity characteristics after infrared component separation according to the second embodiment.

FIG. 21 is a diagram illustrating a use example of the imaging device according to the present disclosure.

FIG. 22 is a block diagram illustrating a system configuration example of a vehicle on which the imaging device according to the present disclosure can be mounted.

FIG. 23 is a block diagram illustrating a configuration of an example of a front sensing camera of a vehicle system.

FIG. 24 is a block diagram illustrating an example of a schematic configuration of a vehicle control system which is an example of a moving body control system to which a technology according to the present disclosure can be applied.

FIG. 25 is a diagram illustrating an example of an installation position of the imaging unit.

Description of Embodiments

Hereinafter, embodiments of the present disclosure will be described in detail with reference to the drawings. Note that, in the following embodiments, the same reference signs denote the same portions, and an overlapping description will be omitted.

Hereinafter, embodiments of the present disclosure will be described in the following order.

1. First Embodiment of Present Disclosure

 1-1. Configuration Applicable to First Embodiment
 1-2. Description of Existing Technology
 1-3. Description of First Embodiment
 1-4. First Modified Example of First Embodiment
 1-5. Second Modified Example of First Embodiment

2. Second Embodiment

 2-1. Configuration Applicable to Second Embodiment
 2-2. IR Separation Processing Applicable to Second Embodiment

3. Third Embodiment
3-0. Example of Application to Moving Body

[1. First Embodiment of Present Disclosure]

Hereinafter, a first embodiment of the present disclosure will be described. In the first embodiment, for example, in a case where each of a red (R) color filter, a green (G) color filter, a blue (B) color filter, and a white (W) color filter is provided for each pixel, occurrence of a false color is suppressed by devising an arrangement of the respective color filters and signal processing for a pixel signal read from each pixel.

Here, the red (R) color filter, the green (G) color filter, and the blue (B) color filter are optical filters that selectively transmit light in a red wavelength range, a green wavelength range, and a blue wavelength range, respectively. The white (W) color filter is, for example, an optical filter that transmits light in substantially the entire wavelength range of visible light at a predetermined transmittance or more.

Note that selectively transmitting light in a certain wavelength range means transmitting the light in the wavelength range at a predetermined transmittance or more and making a wavelength range other than the wavelength range have a transmittance less than the predetermined transmittance.

(1-1. Configuration Applicable to First Embodiment)

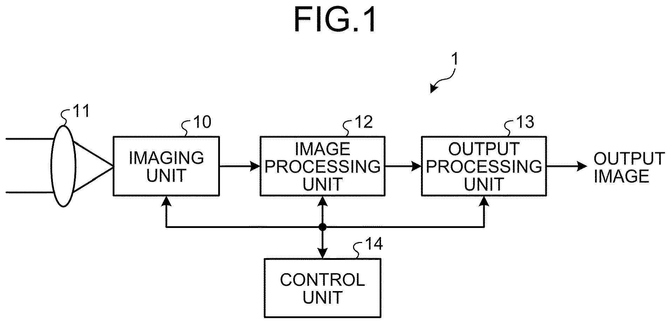

First, a technology applicable to the first embodiment of the present disclosure will be described. FIG. 1 is a functional block diagram of an example for describing functions of an imaging device applicable to the first embodiment. In FIG. 1, an imaging device 1 includes an imaging unit 10, an optical unit 11, an image processing unit 12, an output processing unit 13, and a control unit 14.

The imaging unit 10 includes a pixel array in which a plurality of pixels each including one or more light receiving elements are arranged in a matrix. In the pixel array, an optical filter (color filter) that selectively transmits light in a predetermined wavelength range is provided for each pixel on a one-to-one basis. Furthermore, the optical unit 11 includes a lens, a diaphragm mechanism, a focusing mechanism, and the like, and guides light from a subject to a light receiving surface of the pixel array.

The imaging unit 10 reads a pixel signal from each pixel exposed for a designated exposure time, performs signal processing such as noise removal or gain adjustment on the read pixel signal, and converts the pixel signal into digital pixel data. The imaging unit 10 outputs the pixel data based on the pixel signal. A series of operations of performing exposure, reading a pixel signal from an exposed pixel, and outputting the pixel signal as pixel data by the imaging unit 10 is referred to as imaging.

The image processing unit 12 performs predetermined signal processing on the pixel data output from the imaging unit 10 and outputs the pixel data. The signal processing performed on the pixel data by the image processing unit 12 includes, for example, synchronization processing of causing pixel data of each pixel on which the red (R) color filter, the green (G) color filter, or the blue (B) color filter is provided on a one-to-one basis to have information of each of the colors, R, G, and B. The image processing unit 12 outputs each pixel data subjected to the signal processing.

The output processing unit 13 outputs the image data output from the image processing unit 12, for example, as image data in units of frames. At this time, the output processing unit 13 converts the output image data into a format suitable for output from the imaging device 1. The output image data output from the output processing unit 13 is supplied to, for example, a display (not illustrated) and displayed as an image. Alternatively, the output image data may be supplied to another device such as a device that performs recognition processing on the output image data or a control device that performs a control on the basis of the output image data.

The control unit 14 controls an overall operation of the imaging device 1. The control unit 14 includes, for example, a central processing unit (CPU) and an interface circuit for performing communication with each unit of the imaging device 1, generates various control signals by the CPU operating according to a predetermined program, and controls each unit of the imaging device 1 according to the generated control signal.

Note that the image processing unit 12 and the output processing unit 13 described above can include, for example, a digital signal processor (DSP) or an image signal processor (ISP) that operates according to a predetermined program. Alternatively, one or both of the image processing unit 12 and the output processing unit 13 may be implemented by a program that operates on the CPU together with the control unit 14. These programs may be stored in advance in a nonvolatile memory included in the imaging device 1, or may be supplied from the outside to the imaging device 1 and written in the memory.

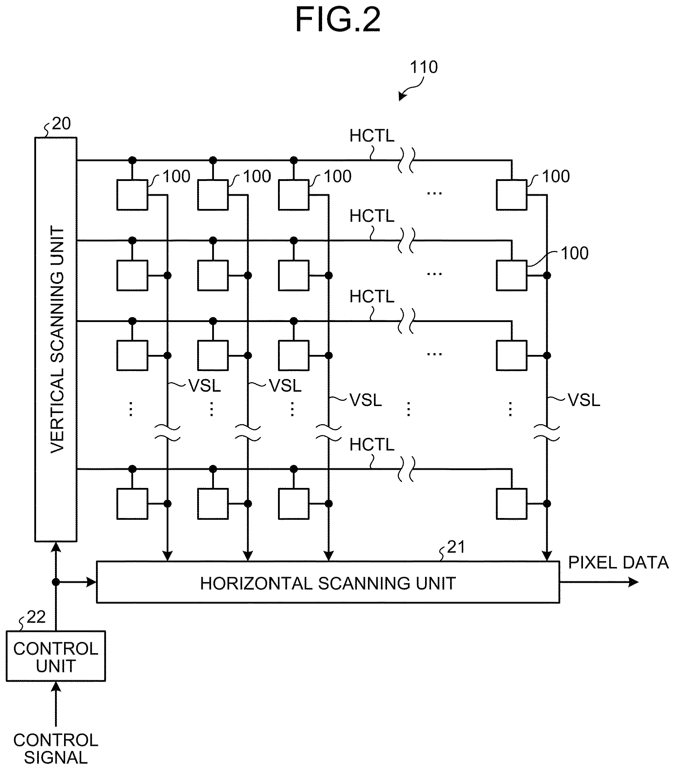

FIG. 2 is a block diagram illustrating a configuration of an example of the imaging unit 10 applicable to each embodiment. In FIG. 2, the imaging unit 10 includes a pixel array unit 110, a vertical scanning unit 20, a horizontal scanning unit 21, and a control unit 22.

The pixel array unit 110 includes a plurality of pixels 100 each including a light receiving element that generates a voltage corresponding to received light. A photodiode can be used as the light receiving element. In the pixel array unit 110, the plurality of pixels 100 are arranged in a matrix in a horizontal direction (row direction) and a vertical direction (column direction). In the pixel array unit 110, an arrangement of the pixels 100 in the row direction is referred to as a line. An image (image data) of one frame is formed on the basis of pixel signals read from a predetermined number of lines in the pixel array unit 110. For example, in a case where an image of one frame is formed with 3000 pixels × 2000 lines, the pixel array unit 110 includes at least 2000 lines each including at least 3000 pixels 100.

In addition, in the pixel array unit 110, a pixel signal line HCTL is connected to each row of the pixels 100, and a vertical signal line VSL is connected to each column of the pixels 100.

An end of the pixel signal line HCTL that is not connected to the pixel array unit 110 is connected to the vertical scanning unit 20. The vertical scanning unit 20 transmits a plurality of control signals such as a drive pulse at the time of reading the pixel signal from the pixel 100 to the pixel array unit 110 via the pixel signal line HCTL according to the control signal supplied from the control unit 14, for example. An end of the vertical signal line VSL that is not connected to the pixel array unit 110 is connected to the horizontal scanning unit 21.

The horizontal scanning unit 21 includes an analog-to-digital (AD) conversion unit, an output unit, and a signal processing unit. The pixel signal read from the pixel 100 is transmitted to the AD conversion unit of the horizontal scanning unit 21 via the vertical signal line VSL.

A control of reading the pixel signal from the pixel 100 will be schematically described. The reading of the pixel signal from the pixel 100 is performed by transferring an electric charge accumulated in the light receiving element by exposure to a floating diffusion (FD) layer, and converting the electric charge transferred to the floating diffusion layer into a voltage. The voltage obtained by converting the electric charge in the floating diffusion layer is output to the vertical signal line VSL via an amplifier.

More specifically, in the pixel 100, during exposure, the light receiving element and the floating diffusion layer are disconnected from each other (open), and an electric charge generated corresponding to incident light by photoelectric conversion is accumulated in the light receiving element. After the exposure is completed, the floating diffusion layer and the vertical signal line VSL are connected according to a selection signal supplied via the pixel signal line HCTL. Further, the floating diffusion layer is connected to a supply line for a power supply voltage VDD or a black level voltage for a short time according to a reset pulse supplied via the pixel signal line HCTL, and the floating diffusion layer is reset. A reset level voltage (referred to as a voltage P) of the floating diffusion layer is output to the vertical signal line VSL. Thereafter, the light receiving element and the floating diffusion layer are connected to each other (closed) by a transfer pulse supplied via the pixel signal line HCTL, and the electric charge accumulated in the light receiving element is transferred to the floating diffusion layer. A voltage (referred to as a voltage Q) corresponding to the amount of the electric charge of the floating diffusion layer is output to the vertical signal line VSL.

In the horizontal scanning unit 21, the AD conversion unit includes an AD converter provided for each vertical signal line VSL, and the pixel signal supplied from the pixel 100 via the vertical signal line VSL is subjected to AD conversion processing by the AD converter, and two digital values (values respectively corresponding to the voltage P and the voltage Q) for correlated double sampling (CDS) processing for performing noise reduction are generated.

The two digital values generated by the AD converter are subjected to the CDS processing by the signal processing unit, and a pixel signal (pixel data) corresponding to a digital signal is generated. The generated pixel data is output from the imaging unit 10.

Under the control of the control unit 22, the horizontal scanning unit 21 performs selective scanning to select the AD converters for the respective vertical signal lines VSL in a predetermined order, thereby sequentially outputting the respective digital values temporarily held by the AD converters to the signal processing unit. The horizontal scanning unit 21 implements this operation by a configuration including, for example, a shift register, an address decoder, and the like.

The control unit 22 performs a drive control of the vertical scanning unit 20, the horizontal scanning unit 21, and the like. The control unit 22 generates various drive signals serving as references for operations of the vertical scanning unit 20 and the horizontal scanning unit 21. The control unit 22 generates a control signal to be supplied by the vertical scanning unit 20 to each pixel 100 via the pixel signal line HCTL on the basis of a vertical synchronization signal or an external trigger signal supplied from the outside (for example, the control unit 14) and a horizontal synchronization signal. The control unit 22 supplies the generated control signal to the vertical scanning unit 20.

On the basis of the control signal supplied from the control unit 22, the vertical scanning unit 20 supplies various signals including a drive pulse to the pixel signal line HCTL of the selected pixel row of the pixel array unit 110 to each pixel 100 line by line, and causes each pixel 100 to output the pixel signal to the vertical signal line VSL. The vertical scanning unit 20 is implemented by using, for example, a shift register, an address decoder, and the like.

The imaging unit 10 configured as described above is a column AD system complementary metal oxide semiconductor (CMOS) image sensor in which the AD converters are arranged for each column.

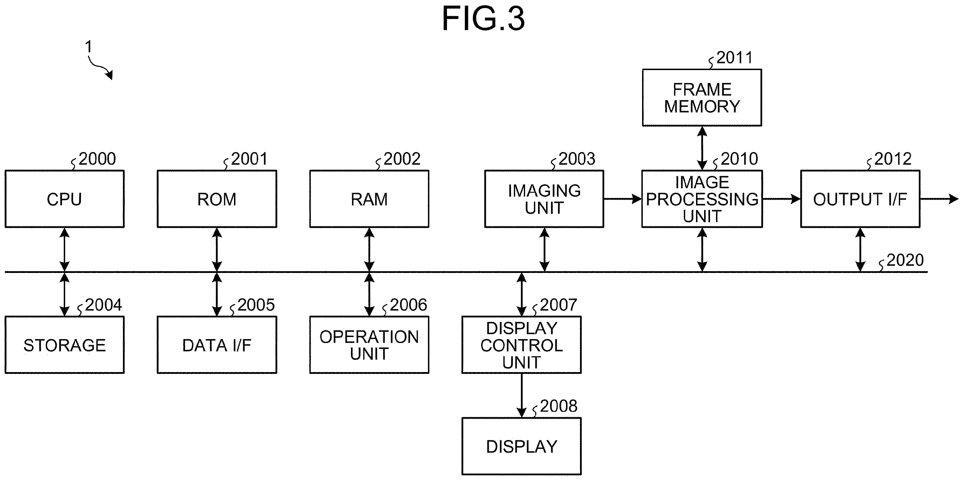

FIG. 3 is a block diagram illustrating an example of a hardware configuration of the imaging device 1 applicable to the first embodiment. In FIG. 3, the imaging device 1 includes a CPU 2000, a read only memory (ROM) 2001, a random access memory (RAM) 2002, an imaging unit 2003, a storage 2004, a data interface (I/F) 2005, an operation unit 2006, and a display control unit 2007, each of which is connected by a bus 2020. In addition, the imaging device 1 includes an image processing unit 2010 and an output I/F 2012, each of which is connected by the bus 2020.

The CPU 2000 controls an overall operation of the imaging device 1 by using the RAM 2002 as a work memory according to a program stored in advance in the ROM 2001.

The imaging unit 2003 corresponds to the imaging unit 10 in FIG. 1, performs imaging, and outputs pixel data. The pixel data output from the imaging unit 2003 is supplied to the image processing unit 2010. The image processing unit 2010 corresponds to the image processing unit 12 of FIG. 1 and includes a part of the functions of the output processing unit 13. The image processing unit 2010 performs predetermined signal processing on the pixel data supplied from the imaging unit 10, and sequentially writes the pixel data in the frame memory 2011. The pixel data corresponding to one frame written in the frame memory 2011 is output from the image processing unit 2010 as image data in units of frames.

The output I/F 2012 is an interface for outputting the image data output from the image processing unit 2010 to the outside. The output I/F 2012 includes, for example, some functions of the output processing unit 13 of FIG. 1, and can convert the image data supplied from the image processing unit 2010 into image data of a predetermined format and output the image data.

The storage 2004 is, for example, a flash memory, and can store and accumulate the image data output from the image processing unit 2010. The storage 2004 can also store a program for operating the CPU 2000. Furthermore, the storage 2004 is not limited to the configuration built in the imaging device 1, and may be detachable from the imaging device 1.

The data I/F 2005 is an interface for the imaging device 1 to transmit and receive data to and from an external device. For example, a universal serial bus (USB) can be applied as the data I/F 2005. Furthermore, an interface that performs short-range wireless communication such as Bluetooth (registered trademark) can be applied as the data I/F 2005.

The operation unit 2006 receives a user operation with respect to the imaging device 1. The operation unit 2006 includes an operable element such as a dial or a button as an input device that receives a user input. The operation unit 2006 may include, as an input device, a touch panel that outputs a signal corresponding to a contact position.

The display control unit 2007 generates a display signal displayable by a display 2008 on the basis of a display control signal transferred by the CPU 2000. The display 2008 uses, for example, a liquid crystal display (LCD) as a display device, and displays a screen according to the display signal generated by the display control unit 2007. Note that the display control unit 2007 and the display 2008 can be omitted depending on the application of the imaging device 1.

(1-2. Description of Existing Technology)

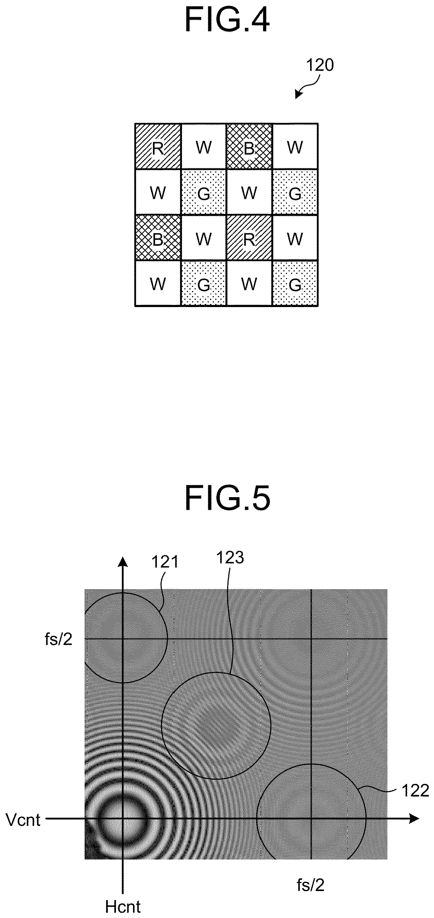

Prior to a detailed description of the first embodiment, an existing technology related to the present disclosure will be described for easy understanding. FIG. 4 is a schematic diagram illustrating an example of a pixel arrangement using each of an R color filter, a G color filter, a B color filter, and a W color filter according to the existing technology. In the example of FIG. 4, with a pixel block 120 of 4 × 4 pixels as a unit, eight pixels on which the W color filters are provided are arranged in a mosaic pattern, that is, the pixels are arranged alternately in vertical and horizontal directions of the pixel block 120. Furthermore, two pixels on which the R color filters are provided, two pixels on which the B color filters are provided, and four pixels on which the G color filters are provided are arranged so that the pixels on which the color filters of the same color are provided are not adjacent to each other in an oblique direction.

Hereinafter, a pixel on which the R color filter is provided is referred to as a pixel R. The same applies to pixels on which the G color filter, the B color filter, and the W color filter are provided, respectively.

More specifically, in the example of FIG. 4, in the pixel block 120 in which the pixels are arranged in a matrix pattern of 4 × 4 pixels, the respective pixels are arranged in the order of the pixel R, the pixel W, the pixel B, and the pixel W from the left in a first row which is an upper end row, and the respective pixels are arranged in the order of the pixel W, the pixel G, the pixel W, the pixel W, and the pixel G from the left in a second row. A third row and a fourth row are repetition of the first row and the second row.

In such a pixel arrangement, the synchronization processing is performed on the pixel R, the pixel G, and the pixel B, and the pixels at the respective positions of the pixel R, the pixel G, and the pixel B are caused to have R, G, and B color components. In the synchronization processing, for example, in a pixel of interest (here, the pixel R), a pixel value of the pixel of interest is used for the R color component. Furthermore, the component of the color (for example, the G color) other than the pixel R is estimated from a pixel value of the pixel G in the vicinity of the pixel of interest. Similarly, the B color component is estimated from a pixel value of the pixel B in the vicinity of the pixel of interest. The component of each color can be estimated using, for example, a low-pass filter.

It is possible to make the pixel R, the pixel G, and the pixel B have the R, G, and B color components, respectively, by applying the above processing to all the pixels R, G, and B included in the pixel array. A similar method can be applied to the pixel W. Furthermore, in the pixel arrangement of FIG. 4, high sensitivity can be obtained by arranging the pixels W in a mosaic pattern.

FIG. 5 is a diagram illustrating an example of a captured image obtained by capturing an image of a circular zone plate (CZP) using an imaging device in which the pixel array has the pixel arrangement according to the existing technology illustrated in FIG. 4. FIG. 5 illustrates a region corresponding to approximately 1/4 of the entire captured image obtained by capturing the image of the CZP, the region including a vertical center line Hcnt and a horizontal center line Vcnt. Note that, in FIG. 5, a value fs indicates a sampling frequency and corresponds to a pixel pitch in the pixel array. Hereinafter, a description will be given assuming that the value fs is a frequency fs.

Referring to FIG. 5, it can be seen that false colors occur at a position 121 corresponding to a frequency fs/2 on the vertical center line Hcnt and a position 122 corresponding to a frequency fs/2 on the horizontal center line Vcnt. In addition, it can be seen that a false color also occurs at a position 123 in an oblique direction corresponding to frequencies fs/4 in the vertical and horizontal directions with respect to a center position. That is, in the vertical and horizontal directions, a strong false color occurs in a frequency band corresponding to the frequency fs/2. In addition, in the oblique direction, a strong false color occurs in a frequency band corresponding to the frequency fs/4.

Here, referring to the pixel arrangement of FIG. 4, for example, rows and columns including only the pixels G among the pixels R, G, and B appear every other row and column. The other rows and columns include the pixels R and B among the pixels R, G, and B, and do not include the pixels G. Furthermore, there are an oblique line including the pixels R and G among the pixels R, G, and B and does not include the pixels B and an oblique line including the pixels G and B among the pixels R, G, and B and does not include the pixels R.

As described above, in the existing pixel arrangement, there are lines that do not include a pixel of a specific color in the row direction, the column direction, and the oblique direction. Therefore, a bias occurs in the synchronization processing, and for example, a strong false color occurs in the frequency band corresponding to the frequency fs/2 in the vertical and horizontal directions and the frequency band corresponding to the frequency fs/4 in the oblique direction. Furthermore, in a case where a false color occurring by the pixel arrangement of the existing technology is handled by signal processing, a complicated circuit is required, and there is a possibility that a side effect such as achromatization of a chromatic subject occurs.

(1-3. Description of First Embodiment)

Next, the first embodiment will be described. The first embodiment proposes a pixel arrangement including all the pixels R, G, and B in each of the row direction, the column direction, and the oblique direction in the pixel arrangement using the pixels R, G, and B and the pixel W. Furthermore, the occurrence of a false color is suppressed by simple signal processing for pixel signals read from the pixels R, G, and B.

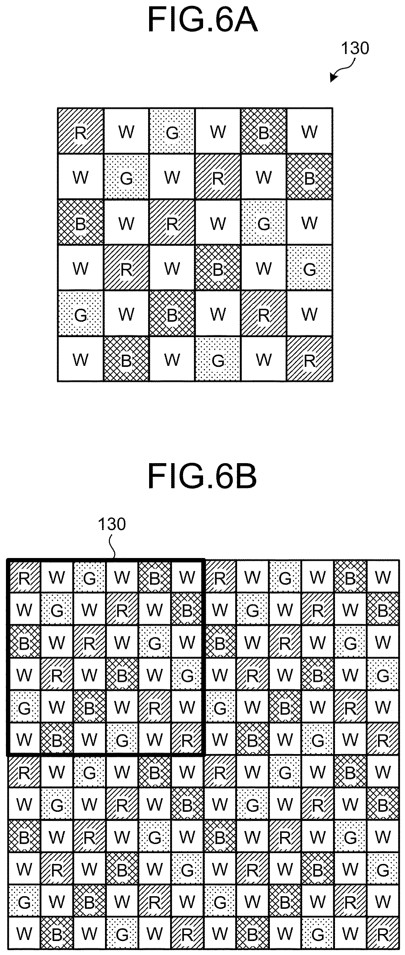

FIGS. 6A and 6B are schematic diagrams illustrating an example of a pixel arrangement applicable to the first embodiment. In the first embodiment, as illustrated in FIG. 6A, a pixel block 130 of 6 × 6 pixels is used as a unit. In FIG. 6A, the pixel block 130 includes a first optical filter that transmits light in a first wavelength range, a second optical filter that selectively transmits light in a second wavelength range, a third optical filter that selectively transmits light in a third wavelength range, and a fourth optical filter that selectively transmits light in a fourth wavelength range.

The first optical filter is, for example, a color filter that transmits light in substantially the entire visible light range, and the above-described W color filter can be applied. The second optical filter is, for example, the R color filter that selectively transmits light in the red wavelength range. The third optical filter is, for example, the G color filter that selectively transmits light in the green wavelength range. Similarly, the fourth optical filter is, for example, the B color filter that selectively transmits light in the blue wavelength range.

In the example of FIG. 6A, the pixels W on which the W color filters are provided are arranged in a mosaic pattern in the pixel block 130, that is, the pixels W are arranged alternately in the row direction and the column direction. The pixel R on which the R color filter is provided, the pixel G on which the G color filter is provided, and the pixel B on which the B color filter is provided are arranged so that one pixel R, one pixel G, and one pixel B are included for each row and each column in the pixel block 130.

Here, in the example of FIG. 6A, each row of the pixel block 130 includes all permutations of the pixels R, G, and B. That is, the number of permutations in a case where one pixel R, one pixel G, and one pixel B are selected and arranged is 3! = 6, and the pixels R, G, and B in the six rows included in the pixel block 130 are differently arranged. Specifically, in a case where an upper end of the pixel block 130 is a first row and the pixels R, G, and B are represented as R, G, and B, respectively, in the example of FIG. 6A, the pixels R, G, and B are arranged in the order of (R, G, B) in the first row, arranged in the order of (G, R, B) in a second row, arranged in the order of (B, R, G) in a third row, arranged in the order of (R, B, G) in a fourth row, arranged in the order of (G, B, R) in a fifth row, and arranged in the order of (B, G, R) in a sixth row, from the left.

Furthermore, the pixel block 130 includes an oblique line including at least one pixel R, one pixel G, and one pixel B in a first oblique direction that is parallel to a diagonal of the pixel block 130, and an oblique line including at least one pixel R, one pixel G, and one pixel B in a second oblique direction that is parallel to a diagonal of the pixel block 130 and is different from the first oblique direction.

FIG. 6B is a schematic diagram illustrating an example in which the pixel block 130 illustrated in FIG. 6A is repeatedly arranged. Here, in the example illustrated in FIG. 6B in which a plurality of pixel blocks 130 are arranged, even in a case where a pixel block of 6 × 6 pixels is arbitrarily designated from all the pixel blocks 130, it can be seen that the above-described condition that "one pixel R, one pixel G, and one pixel B are included for each row and each column" is satisfied in the designated pixel block. Further, each row of the arbitrarily designated pixel block includes all permutations of the pixels R, G, and B.

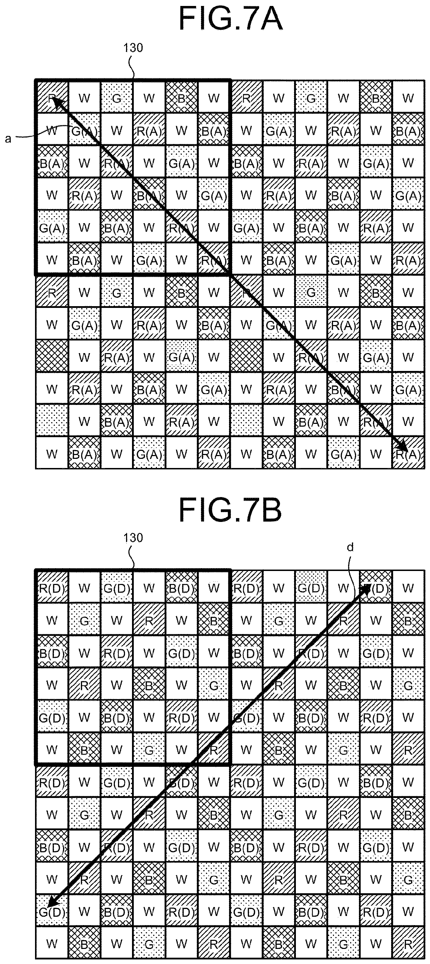

In the pixel arrangement illustrated in FIGS. 6A and 6B, two series are extracted, and the synchronization processing is performed for the two series in an independent manner. FIGS. 7A and 7B are schematic diagrams for describing two series to be subjected to the synchronization processing according to the first embodiment. FIG. 7A is a diagram for describing a first series of two series to be subjected to the synchronization processing, and FIG. 7B is a diagram for describing a second series of the two series.

In FIG. 7A, pixels extracted as the first series are illustrated in a form in which "(A)" is added to "R", "G", and "B" indicating the pixels R, G, and B, respectively. As illustrated as "R(A)", "G(A)", and "B(A)" in FIG. 7A, the pixels R, G, and B included in the second, fourth, and sixth rows of the pixel block 130 are extracted as the pixels included in the first series. Hereinafter, a pixel group including the pixels R, G, and B extracted as the first series is referred to as an A-series pixel group.

On the other hand, in FIG. 7B, pixels extracted as the second series are illustrated in a form in which "(D)" is added to "R", "G", and "B" indicating the pixels R, G, and B, respectively. As illustrated as "R(D)", "G(D)", and "B(D)" in FIG. 7B, the pixels R, G, and B included in the first row, the third row, and the fifth row of the pixel block 130, which are not extracted as the first series in FIG. 7A, are extracted as the second series. Hereinafter, a pixel group including the pixels R, G, and B extracted as the second series is referred to as a D-series pixel group.

Here, in the A-series pixel group illustrated in FIG. 7A, the pixels R, G, and B are repeatedly arranged in a predetermined order in an oblique direction from the upper left to the lower right of the pixel block 130 indicated by an arrow a. Similarly, in the D-series pixel group illustrated in FIG. 7B, the pixels R, G, and B are repeatedly arranged in a predetermined order in an oblique direction from the upper right to the lower left of the pixel block 130 indicated by an arrow d.

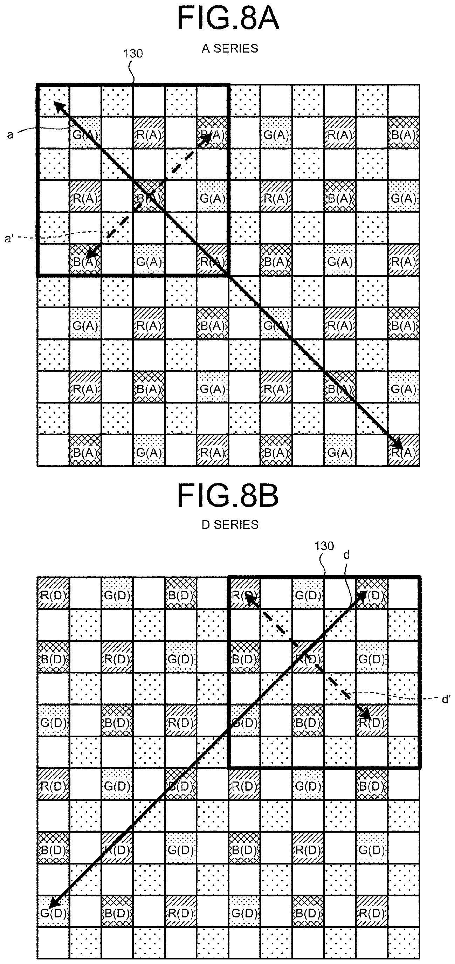

FIGS. 8A and 8B are schematic diagrams illustrating the A-series pixel group and the D-series pixel group extracted from FIGS. 7A and 7B, respectively. As illustrated in FIG. 8A, in the A-series pixel group, the pixels R, G, and B are repeatedly arranged in a predetermined order in which the pixels of the same color are not adjacent to each other in each line in the oblique direction indicated by the arrow a. Similarly, in the D-series pixel group, as illustrated in FIG. 8B, the pixels R, G, and B are repeatedly arranged in a predetermined order in which the pixels of the same color are not adjacent to each other in a line in the oblique direction indicated by the arrow d.

Note that, for example, in FIG. 8A, pixels of the same color are arranged adjacent to each other in each line in an oblique direction that is indicated by an arrow a' and is orthogonal to the direction of the arrow a. Similarly, in FIG.

8B, pixels of the same color are arranged adjacent to each other in each line in an oblique direction that is indicated by an arrow d' and is orthogonal to the direction of the arrow d.

In this manner, each of the A-series pixel group and the D-series pixel group substantially equally includes the pixels R, G, and B in each row and each column. Furthermore, as for the oblique direction, the pixels R, G, and B are substantially equally included in each specific direction. Therefore, by performing the synchronization processing for each of the A-series pixel group and the D-series pixel group in an independent manner and determining values of the R, G, and B colors of the respective pixels on the basis of a result of the synchronization processing, it is possible to obtain an image in which a false color is suppressed.

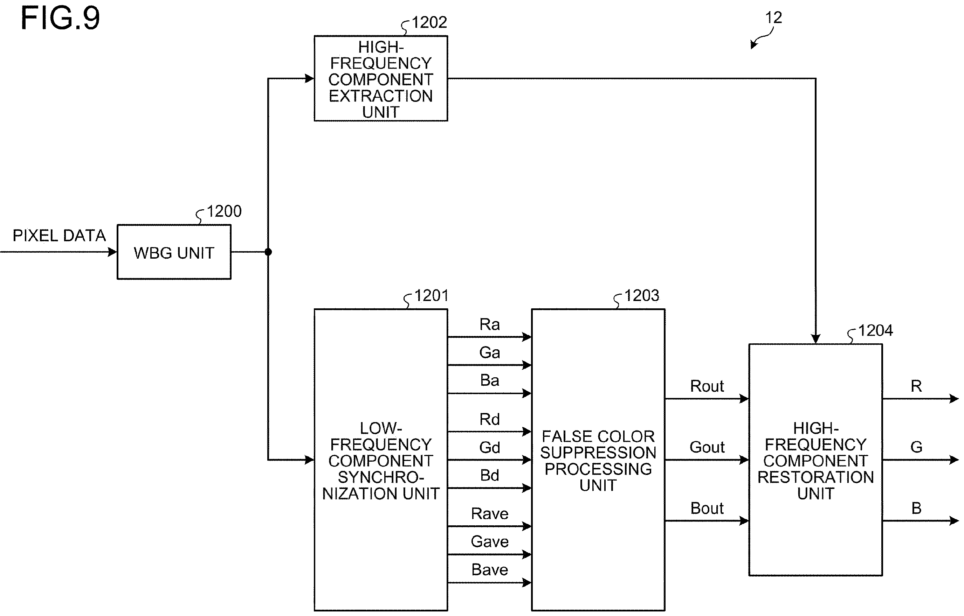

FIG. 9 is a functional block diagram of an example for describing functions of the image processing unit 12 applicable to the first embodiment. In FIG. 9, the image processing unit 12 includes a white balance gain (WBG) unit 1200, a low-frequency component synchronization unit 1201, a high-frequency component extraction unit 1202, a false color suppression processing unit 1203, and a high-frequency component restoration unit 1204.

Pixel data of each of the R, G, B, and W colors output from the imaging unit 10 is input to the WBG unit 1200. The WBG unit 1200 performs white balance processing on the pixel data of each of the R, G, and B colors as necessary. For example, the WBG unit 1200 adjusts a balance of a gain of pixel data of each of the pixel R, the pixel G, and the pixel B by using a gain according to a set color temperature. The pixel data of each of the pixels R, G, B, and W whose white balance gain has been adjusted by the WBG unit 1200 is input to the low-frequency component synchronization unit 1201 and the high-frequency component extraction unit 1202.

The high-frequency component extraction unit 1202 extracts a high-frequency component of input pixel data of the pixel W by using, for example, a high-pass filter. The high-frequency component extraction unit 1202 supplies a value of the extracted high-frequency component to the high-frequency component restoration unit 1204.

The low-frequency component synchronization unit 1201 performs the synchronization processing on the input pixel data of each of the pixels R, G, and B, by using, for example, the low-pass filter. At this time, the low-frequency component synchronization unit 1201 divides the input pixel data of the respective pixels R, G, and B into pixel data (hereinafter, referred to as A-series pixel data) included in the A-series pixel group and pixel data (hereinafter, referred to as D-series pixel data) included in the D-series pixel group described with reference to FIGS. 7A and 7B and FIGS. 8A and 8B. The low-frequency component synchronization unit 1201 performs the synchronization processing based on the A-series pixel data and the synchronization processing based on the D-series pixel data in an independent manner.

More specifically, the low-frequency component synchronization unit 1201 outputs data Ra, Ga, and Ba indicating values of respective R, G, and B color components generated for a target pixel by the synchronization processing based on the A-series pixel data. Similarly, the low-frequency component synchronization unit 1201 outputs data Rd, Gd, and Bd indicating values of the respective R, G, and B color components generated for the target pixel by the synchronization processing based on the D-series pixel data.

Furthermore, the low-frequency component synchronization unit 1201 also performs synchronization processing using the A-series pixel data and the D-series pixel data for the target pixel. For example, the low-frequency component synchronization unit 1201 calculates an average value of component values of the respective colors for the above-described data a, Ga, and Ba and the data Rd, Gd, and Bd. Average data Rave, Gave, and Bave of the components of the respective R, G, and B colors are calculated by, for example, Rave = (Ra - Rd)/2, Gave = (Ga - Gd)/2, and Bave = (Ba - Bd)/2, respectively.

The data Ra, Ga, and Ba, the data Rd, Gd, and Bd, and the data Rave, Gave, and Bave for the target pixel output from the low-frequency component synchronization unit 1201 are input to the false color suppression processing unit 1203.

The false color suppression processing unit 1203 determines which one of a set of the data Ra, Ga, and Ba (referred to as an A-series set), a set of the data Rd, Gd, and Bd (referred to as a D-series set), and a set of the data Rave, Gave, and Bave (referred to as an average value set) is adopted as the output of the low-frequency component synchronization unit 1201 by using a minimum chrominance algorithm.

More specifically, the false color suppression processing unit 1203 calculates a sum of squares of the chrominances for each of the A-series set, the D-series set, and the average value set as illustrated in the following Equations (1), (2), and (3).

$$Cda = (Ra - Ga)^2 + (Ba - Ga)^2 \qquad\qquad (1)$$

$$Cdd = (Rd - Gd)^2 + (Bd - Gd)^2 \qquad\qquad (2)$$

$$Cdave = (Rave - Gave)^2 + (Bave - Gave)^2 \qquad\qquad (3)$$

The false color suppression processing unit 1203 selects the smallest value from among the values Cda, Cdd, and Cdave calculated by Equations (1) to (3), and determines values of the R, G, and B colors of the set for which the selected value is calculated as data Rout, Gout, and Bout indicating values of the R, G, and B color components of the target pixel. The false color suppression processing unit 1203 outputs the data Rout, Gout, and Bout.

The data Rout, Gout, and Bout output from the false color suppression processing unit 1203 are input to the high-frequency component restoration unit 1204. The high-frequency component restoration unit 1204 restores high-frequency components of the data Rout, Gout, and Bout input from the false color suppression processing unit 1203 by a known method using the value of the high-frequency component input from the high-frequency component extraction unit 1202. The high-frequency component restoration unit 1204 outputs the data R, G, and B obtained by restoring the high-frequency components of the data Rout, Gout, and Bout as data indicating the values of the respective R, G, and B color components in the pixel data of the target pixel.

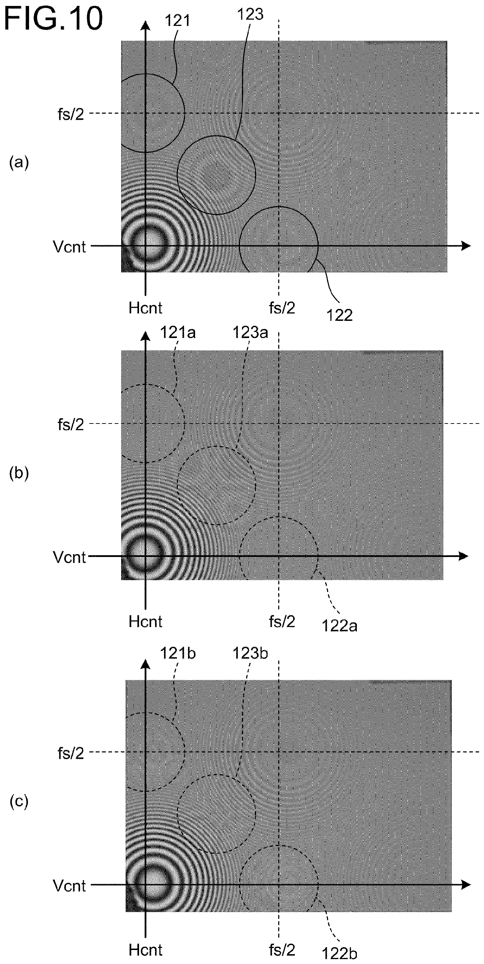

FIG. 10 is a schematic diagram for describing effects of the pixel arrangement and signal processing according to the first embodiment. A section (a) of FIG. 10 is a diagram corresponding to FIG. 5 described above, and is a diagram illustrating an example of a captured image obtained by capturing an image of the CZP by using the imaging device in which the pixel array has the pixel arrangement of the pixel block 120 (see FIG. 4) of 4 × 4 pixels according to the existing technology. Furthermore, each of a section (b) and a section (c) of FIG. 10 is a diagram illustrating an example of a captured image obtained by capturing an image of the CZP by using the imaging device 1 in which the pixel array has the pixel arrangement of the pixel block 130 of 6 × 6 pixels illustrated in FIG. 6A according to the first embodiment.

The section (b) of FIG. 10 is a diagram illustrating an example of a case where the false color suppression processing unit 1203 selects the data of the respective R, G, and B color components of the average value set according to Equation (3) described above as the data Rout, Gout, and Bout respectively indicating the values of the R color component, the G color component, and the B color component of the target pixel. In the example of the diagram of the section (b), it can be seen that false colors corresponding to frequencies fs/2 in the vertical and horizontal directions, respectively, that occurred in the example of the section (a) substantially disappear, as shown at positions 121a and 122a. Furthermore, in the example of the section (b), as shown at a position 123a, a false color branched into four and corresponding to frequencies fs/4 in the vertical and horizontal directions occurs.

The section (c) of FIG. 10 is a diagram illustrating an example of a case where the false color suppression processing unit 1203 obtains the data Rout, Gout, and Bout of the R color component, the G color component, and the B color component of the target pixel using by the above-described minimum chrominance algorithm. In the example of the section (c), it can be seen that, as shown at positions 121b and 122b, the false colors corresponding to the frequencies fs/2 in the vertical and horizontal directions, respectively, occurring in the example of the section (a) are suppressed as compared with the example of the section (a). Furthermore, in the example of the section (c), it can be seen that, as shown at the position 123a, the false colors corresponding to the frequencies fs/4 in the vertical and horizontal directions are suppressed as compared with the examples of the sections (a) and (b).

By applying the pixel arrangement according to the first embodiment in this manner, it is possible to suppress the occurrence of a false color in the captured image in a case where the W color filter is used in addition to the R color filter, the G color filter, and the B color filter in the pixel array by simple signal processing.

(1-4. First Modified Example of First Embodiment)

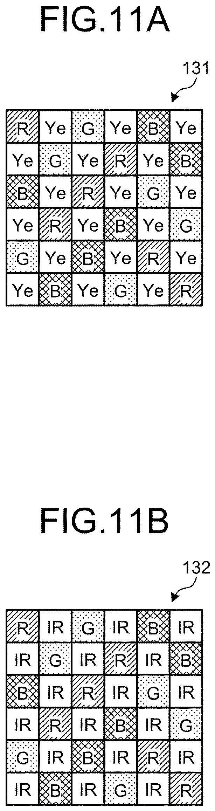

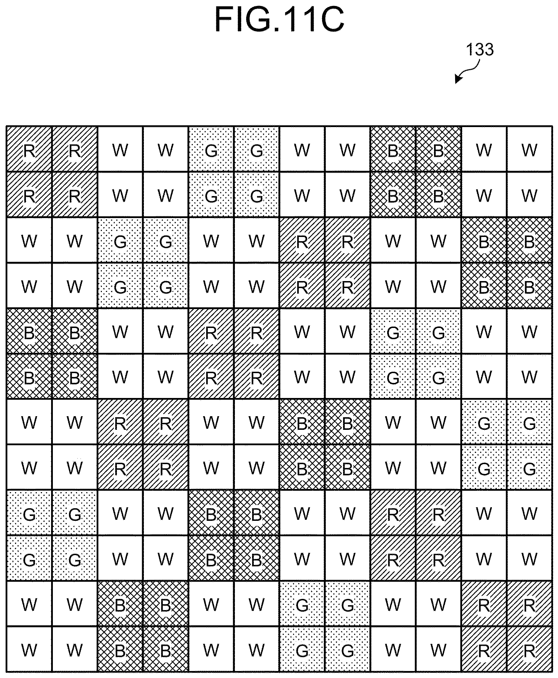

Next, a first modified example of the first embodiment will be described. In the modified example of the first embodiment, another example of the pixel arrangement applicable to the present disclosure will be described. FIGS. 11A, 11B, and 11C are schematic diagrams illustrating another example of the pixel arrangement applicable to the present disclosure.

A pixel block 131 illustrated in FIG. 11A is an example in which the pixel W in the pixel block 130 according to the first embodiment described with reference to FIG. 6A is replaced with a yellow (Ye) color filter that selectively transmits light in a yellow range. A pixel arrangement of the pixel block 131 using the pixel Ye instead of the pixel W has a characteristic of being hardly affected by a lens aberration. The signal processing described with reference to FIG. 9 can be applied to the imaging unit 10 to which the pixel block 131 of the pixel arrangement illustrated in FIG. 11A is applied.

A pixel block 132 illustrated in FIG. 11B is an example in which the pixel W in the pixel block 130 according to the first embodiment described with reference to FIG. 6A is replaced with an infrared (IR) filter that selectively transmits light in an infrared range, and infrared light can be detected. In a case where the pixel block 132 of a pixel arrangement illustrated in FIG. 11B is applied to the imaging unit 10, for example, the processing performed by the high-frequency component extraction unit 1202 and the high-frequency component restoration unit 1204 in FIG. 9 can be omitted.

FIG. 11C is an example of a pixel arrangement in which a small pixel block in which 2 × 2 pixels on which color filters of the same color are provided are arranged in a grid lattice pattern are used as a unit. In a pixel block 133 of FIG. 11C, the small pixel block is regarded as one pixel, and small pixel blocks R, G, B, and W of the respective colors are arranged as the pixels R, G, B, and W, respectively, in the same arrangement as the pixel block 130 of FIG. 6. With the pixel block 133, higher sensitivity can be achieved by adding pixel data of four pixels included in the small pixel block and using the pixel data as pixel data of one pixel. The signal processing described with reference to FIG. 9 can be applied to the imaging unit 10 to which the pixel block 133 of the pixel arrangement illustrated in FIG. 11C is applied in a manner in which the small pixel block is regarded as one pixel.

The present disclosure is not limited to the examples of FIGS. 11A to 11C described above, and can be applied to other pixel arrangements as long as the pixel arrangement uses color filters of four colors and uses a pixel block of 6 × 6 pixels as a unit.

(1-5. Second Modified Example of First Embodiment)

Next, a second modified example of the first embodiment will be described. In the first embodiment described above, since the simple false color suppression processing is used in the false color suppression processing unit 1203, the false colors corresponding to the frequencies fs/2 in the vertical and horizontal directions occur as shown at the positions 121b and 122b of the section (c) of FIG. 10. On the other hand, in the example illustrated in the section (b) of FIG. 10, it can be seen that the false colors corresponding to the frequencies fs/2 in the vertical and horizontal directions are effectively suppressed as compared with the example illustrated in the section (c) of FIG. 10.

As described above, the false color corresponding to the frequency fs/2 in each of the vertical direction and the horizontal direction can be effectively suppressed by using the values of the R, G, and B colors of the average value set. Therefore, in the second modified example of the first embodiment, processing to be used for false color suppression is determined according to the input pixel data.

For example, in a case where the high-frequency component extraction unit 1202 extracts a component of the frequency fs/2 at a predetermined level or higher from the input pixel data, the false color suppression processing unit 1203 performs the false color suppression processing by using the average value according to Equation (3) described above on the pixel data.

The present disclosure is not limited thereto, and the false color suppression processing unit 1203 may apply an offset to the calculation result of Equation (3) in the calculation of Equations (1) to (3) described above, and increase a ratio at which the false color suppression processing using the average value is performed.

In the second modified example of the first embodiment, since the false color suppression processing using the average value of Equation (3) is preferentially performed, the false color corresponding to the frequency fs/2 in each of the vertical and horizontal directions can be more effectively suppressed.

[2. Second Embodiment]

Next, a second embodiment of the present disclosure will be described. The second embodiment is an example in which the pixel arrangement of the pixel block 130 of 6 × 6 pixels illustrated in FIG. 9A is applied as a pixel arrangement, and an IR component is removed from pixel data of each of R, G, and B colors subjected to false color suppression processing.

(2-1. Configuration Applicable to Second Embodiment)

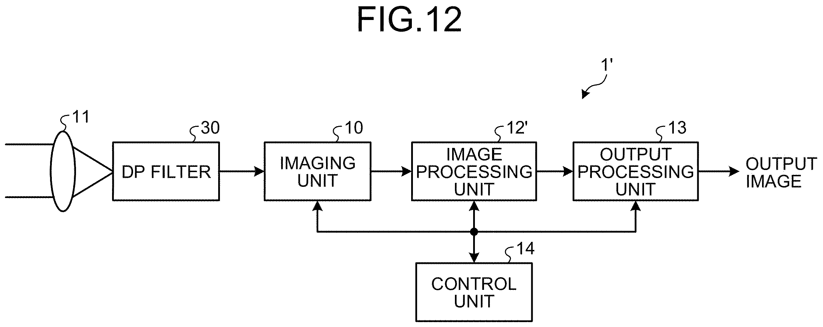

First, a configuration applicable to the second embodiment will be described. FIG. 12 is a functional block diagram of an example for describing functions of an imaging device applicable to the second embodiment. In FIG. 12, an imaging device 1' is different from the imaging device 1 according to the first embodiment described with reference to FIG. 1 in that a dual bandpass filter (DPF) 30 is added between an imaging unit 10 and an optical unit 11, and a function of an image processing unit 12' is different from that of the image processing unit 12 of the imaging device 1.

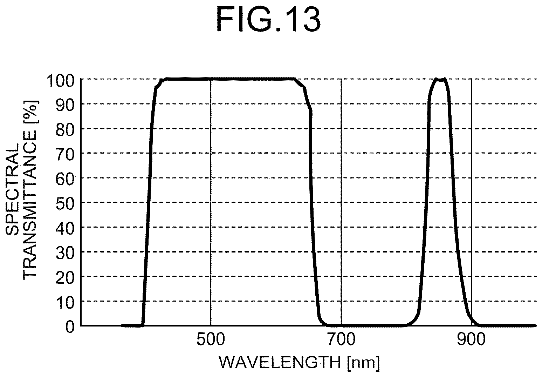

FIG. 13 is a diagram illustrating an example of a transmission characteristic of the dual bandpass filter 30 applicable to the second embodiment. In FIG. 13, a vertical axis represents a spectral transmittance of the dual bandpass filter 30, and a horizontal axis represents a wavelength of light. As illustrated in FIG. 13, the dual bandpass filter 30 transmits, for example, visible light in a wavelength range of 380 to 650 [nm] and infrared light having a longer wavelength. The light transmitted through the dual bandpass filter 30 is incident on the imaging unit 10.

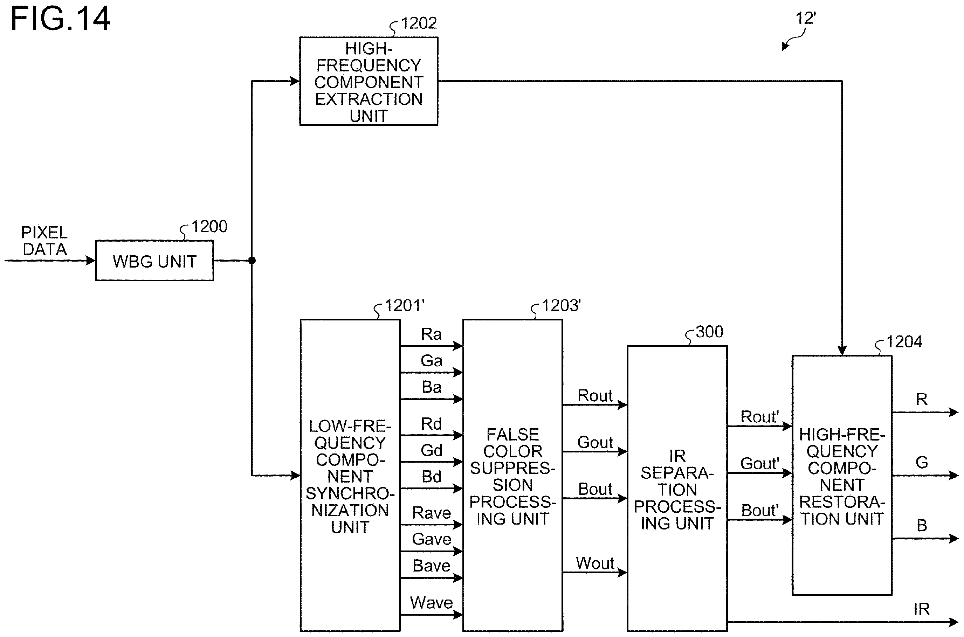

FIG. 14 is a functional block diagram of an example for describing functions of the image processing unit 12' applicable to the second embodiment. In FIG. 14, the image processing unit 12' includes a white balance gain (WBG) unit 1200, a low-frequency component synchronization unit 1201', a high-frequency component extraction unit 1202, a false color suppression processing unit 1203', an IR separation processing unit 300, and a high-frequency component restoration unit 1204.

Pixel data of each of the R, G, B, and W colors output from the imaging unit 10 is subjected to white balance processing by the WBG unit 1200 as necessary, and is input to each of the low-frequency component synchronization unit 1201' and the high-frequency component extraction unit 1202. The high-frequency component extraction unit 1202 extracts a high-frequency component of the input pixel data of the pixel W, and supplies a value of the extracted high-frequency component to the high-frequency component restoration unit 1204.

The low-frequency component synchronization unit 1201' performs the synchronization processing on the input pixel data of each of the pixels R, G, and B, similarly to the low-frequency component synchronization unit 1201 illustrated in FIG. 9. Similarly to the above, the low-frequency component synchronization unit 1201 divides the input pixel data of the pixels R, G, and B into the A-series pixel data and the D-series pixel data, and performs the synchronization processing based on the A-series pixel data and the synchronization processing based on the D-series pixel data in an independent manner.

That is, the low-frequency component synchronization unit 1201' outputs data Ra, Ga, and Ba indicating values of respective R, G, and B color components generated for a target pixel by the synchronization processing based on the A-series pixel data, similarly to the low-frequency component synchronization unit 1201 illustrated in FIG. 9. Similarly, the low-frequency component synchronization unit 1201 outputs data Rd, Gd, and Bd indicating values of the respective R, G, and B color components generated for the target pixel by the synchronization processing based on the D-series pixel data. Furthermore, the low-frequency component synchronization unit 1201' calculates and outputs average data Rave, Gave, and Bave for each color, for the data Ra, Ga, and Ba and the data Rd, Gd, and Bd described above.

Furthermore, the low-frequency component synchronization unit 1201' performs, for example, low-pass filtering processing on pixel data of the W color to generate data Wave based on the average value of the pixel data of the W color. For the data Wave, for example, an average of pixel values (in a case where the target pixel is the pixel W, a pixel value of the target pixel is also included) of the pixels W around the target pixel is calculated and output.

The data Ra, Ga, and Ba, the data Rd, Gd, and Bd, the data Rave, Gave, and Bave, and the data Wave for the target pixel output from the low-frequency component synchronization unit 1201' are input to the false color suppression processing unit 1203'. Similarly to the first embodiment, for example, the false color suppression processing unit 1203' determines which one of a set of the data Ra, Ga, and Ba (A-series set), a set of the data Rd, Gd, and Bd (D-series set), and a set of the data Rave, Gave, and Bave (average value set) is adopted as the output of the low-frequency component synchronization unit 1201 by using a minimum chrominance algorithm. The false color suppression processing unit 1203' outputs values indicating the respective R, G, and B color components of the set determined to be adopted, as the data Rout, Gout, and Bout of the target pixel.

On the other hand, the false color suppression processing unit 1203' outputs the input data Wave as data Wout without applying any processing, for example.

The data Rout, Gout, Bout, and Wout output from the false color suppression processing unit 1203' are input to the IR separation processing unit 300. The IR separation processing unit 300 separates infrared range components from the data Rout, Gout, and Bout on the basis of the input data Rout, Gout, Bout, and Wout. The data Rout', Gout', and Bout' from which the infrared range components have been separated (removed) are output from the false color suppression processing unit 1203'.

Furthermore, the IR separation processing unit 300 can output the data IR indicating values of the infrared range components separated from the data Rout, Gout, and Bout to the outside of the image processing unit 12', for example.

The data Rout', Gout', and Bout' output from the IR separation processing unit 300 are input to the high-frequency component restoration unit 1204. The high-frequency component restoration unit 1204 restores high-frequency components of the data Rout', Gout', and Bout' input from the false color suppression processing unit 1203' by a known method using the value of the high-frequency component input from the high-frequency component extraction unit 1202. The high-frequency component restoration unit 1204 outputs the data R, G, and B obtained by restoring the high-frequency components of the data Rout', Gout', and Bout' as data of the respective R, G, and B colors in the pixel data of the target pixel.

(2-2. IR Separation Processing Applicable to Second Embodiment)

The processing performed by the IR separation processing unit 300 applicable to the second embodiment will be described in more detail. In the second embodiment, a technology described in Patent Literature 2 can be applied to the processing in the IR separation processing unit 300.

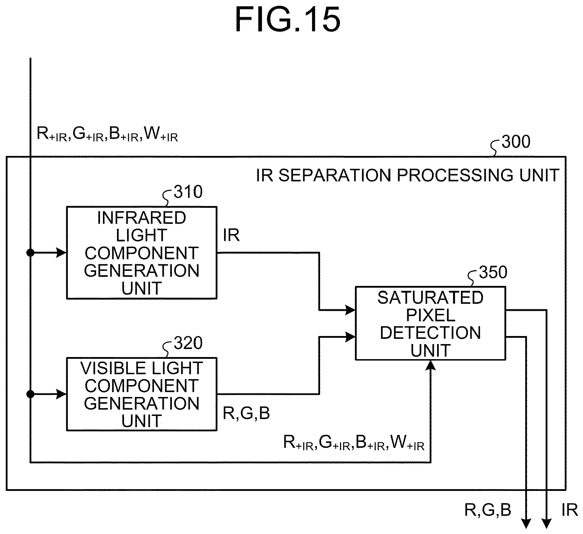

FIG. 15 is a functional block diagram of an example for describing functions of the IR separation processing unit 300 applicable to the second embodiment. In FIG. 15, the IR separation processing unit 300 includes an infrared light component generation unit 310, a visible light component generation unit 320, and a saturated pixel detection unit 350. Note that, in the following, the data Rout, Gout, Bout, and Wout input to the IR separation processing unit 300 are described as data $R_{+IR}$, $G_{+IR}$, $B_{+IR}$, and $W_{+IR}$ each including the infrared range component.

The infrared light component generation unit 310 generates the data IR that is a value indicating the infrared range component. The infrared light component generation unit 310 generates, as the data IR, a value obtained by performing weighted addition of the respective data $R_{+IR}$, $G_{+IR}$, $B_{+IR}$, and $W_{+IR}$ with different coefficients $K_{11}$, $K_{12}$, $K_{13}$,

and $K_{14}$. For example, the weighted addition is performed by the following Equation (4).

$$IR = K_{41} \times R_{+IR} + K_{42} \times G_{+IR} + K_{43} \times B_{+IR} + K_{44} \times W_{+IR} \qquad (4)$$

Here, $K_{41}$, $K_{42}$, $K_{43}$, and $K_{44}$, are set to values at which an addition value obtained by performing weighted addition of sensitivities of the respective pixels R, G, B, and W to the visible light with coefficients thereof becomes an allowable value or less. However, signs of $K_{41}$, $K_{42}$, and $K_{43}$ are the same, and a sign of $K_{44}$ is different from those of $K_{41}$, $K_{42}$, and $K_{43}$. The allowable value is set to a value less than an addition value in a case where $K_{41}$, $K_{42}$, $K_{43}$, and $K_{44}$ are 0.5, 0.5, 0.5, and -0.5, respectively.

Note that it is more desirable to set, as these coefficients, values at which an error between a value obtained by performing weighted addition of the sensitivities of the respective pixels R, G, B, and W and a predetermined target sensitivity of the pixel to the infrared light is equal to or less than a predetermined set value. The set value is set to a value less than an error in a case where $K_{41}$, $K_{42}$, $K_{43}$, and $K_{44}$ are 0.5, 0.5, 0.5, and -0.5, respectively. In addition, it is more desirable to set $K_{41}$, $K_{42}$, $K_{43}$, and $K_{44}$ to values at which the above-described error is minimized.

The visible light component generation unit 320 generates data R, G, and B including visible light components of the respective R, G, and B colors. The visible light component generation unit 320 generates, as the data R indicating a value of the R color component, a value obtained by performing weighted addition of the respective data $R_{+IR}$, $G_{+IR}$, $B_{+IR}$, and $W_{+IR}$ with different coefficients $K_{11}$, $K_{12}$, $K_{13}$, and $K_{14}$. In addition, the visible light component generation unit 320 generates, as the data G indicating a value of the G color component, a value obtained by performing weighted addition of the respective data with different coefficients $K_{21}$, $K_{22}$, $K_{23}$, and $K_{24}$. In addition, the visible light component generation unit 320 generates, as the data B indicating a value of the B color component, a value obtained by performing weighted addition of the respective pixel data with different coefficients $K_{31}$, $K_{32}$, $K_{33}$, and $K_{34}$. For example, the weighted addition is performed by the following Equations (5) to (7).

$$R = K_{11} \times R_{+IR} + K_{12} \times G_{+IR} + K_{13} \times B_{+IR} + K_{14} \times W_{+IR} \qquad (5)$$

$$G = K_{21} \times R_{+IR} + K_{22} \times G_{+IR} + K_{23} \times B_{+IR} + K_{24} \times W_{+IR} \qquad (6)$$

$$B = K_{31} \times R_{+IR} + K_{32} \times G_{+IR} + K_{33} \times B_{+IR} + K_{34} \times W_{+IR} \qquad (7)$$

Here, $K_{11}$ to $K_{14}$ are set to values at which an error between a value obtained by performing weighted addition of the sensitivities of the respective pixels R, G, B, and W with the coefficients thereof and a target sensitivity of the pixel R to the visible light is equal to or less than a predetermined set value. The set value is set to a value less than an error in a case where $K_{11}$, $K_{12}$, $K_{13}$, and $K_{14}$ are 0.5, - 0.5, -0.5, and 0.5, respectively. Note that it is more desirable that $K_{11}$ to $K_{14}$ are set to values at which the error is minimized.

Further, $K_{21}$ to $K_{24}$ are set to values at which an error between a value obtained by performing weighted addition of the sensitivities of the respective pixels R, G, B, and W with the coefficients thereof and a target sensitivity of the pixel G to the visible light is equal to or less than a predetermined set value. The set value is set to a value less than an error in a case where $K_{21}$, $K_{22}$, $K_{23}$, and $K_{24}$ are -0.5, 0.5, -0.5, and 0.5, respectively. Note that it is more desirable that $K_{21}$ to $K_{24}$ are set to values at which the error is minimized.

Further, $K_{31}$ to $K_{34}$ are set to values at which an error between a value obtained by performing weighted addition of the sensitivities of the respective pixels R, G, B, and W with the coefficients thereof and a target sensitivity of the pixel B to the visible light is equal to or less than a predetermined set value. The set value is set to a value less than an error in a case where $K_{31}$, $K_{32}$, $K_{33}$, and $K_{34}$ are -0.5, -0.5, 0.5, and 0.5, respectively. Note that it is more desirable that $K_{31}$ to $K_{34}$ are set to values at which the error is minimized.

The visible light component generation unit 320 supplies the generated data R, G, and B indicating the values of the respective R, G, and B color components to the saturated pixel detection unit 350.

The saturated pixel detection unit 350 detects whether or not a signal level of a component indicating the value of each of the R, G, and B color components is higher than a predetermined threshold value Th2. In a case where the signal level is higher than the predetermined threshold value Th2, the saturated pixel detection unit 350 sets, as a coefficient $\alpha$, a smaller value of "0" to "1" for a higher signal level, and in a case where the signal level is equal to or lower than the threshold value Th2, the saturated pixel detection unit 350 sets "1" as the coefficient $\alpha$. Then, the saturated pixel detection unit 350 processes the data IR including the infrared light component, the data R, G, and B including the visible light component, and the data $R_{+IR}$, $G_{+IR}$, and $B_{+IR}$ by using the following Equations (8) to (11).

$$R = \alpha \times R + (1 - \alpha) \times R_{+IR} \qquad\qquad (8)$$

$$G = \alpha \times G + (1 - \alpha) \times G_{+IR} \qquad\qquad (9)$$

$$B = \alpha \times B + (1 - \alpha) \times B_{+IR} \qquad\qquad (10)$$

$$IR = \alpha \times IR \qquad\qquad (11)$$

With this processing, even in a case where a saturated pixel whose signal level exceeds the threshold value Th2 is detected, an accurate visible light component and infrared light component are obtained. The saturated pixel detection unit 350 outputs the processed data R, G, and B including the visible light components from the IR separation processing unit 300. Furthermore, the saturated pixel detection unit 350 outputs the processed data IR including the infrared light component to the outside of the image processing unit 12'.

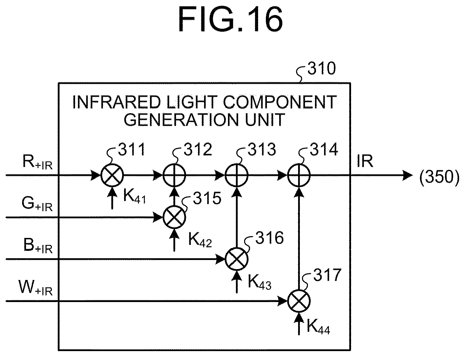

FIG. 16 is a functional block diagram of an example for describing functions of the infrared light component generation unit 310 applicable to the second embodiment. The infrared light component generation unit 310 includes multipliers 311, 315, 316, and 317 and adders 312, 313, and 314.

The multiplier 311 multiplies the data $R_{+IR}$ by the coefficient $K_{41}$ and supplies the multiplication result to the adder 312. The multiplier 315 multiplies the data $G_{+IR}$ by the coefficient $K_{42}$ and supplies the multiplication result to the adder 312. The multiplier 316 multiplies the data $B_{+IR}$ by the coefficient $K_{43}$ and supplies the multiplication result to the adder 313. The multiplier 317 multiplies the data $W_{+IR}$ by the coefficient $K_{44}$ and supplies the multiplication result to the adder 314.

The adder 312 adds the multiplication results from the multipliers 311 and 315 and supplies the addition result to the adder 313. The adder 313 adds the multiplication result from the multiplier 316 and the addition result from the adder 312, and supplies the addition result to the adder 314. The adder 314 adds the multiplication result from the multiplier 317 and the addition result from the adder 313, and supplies, to the saturated pixel detection unit 350, the addition result as an infrared light component IR.

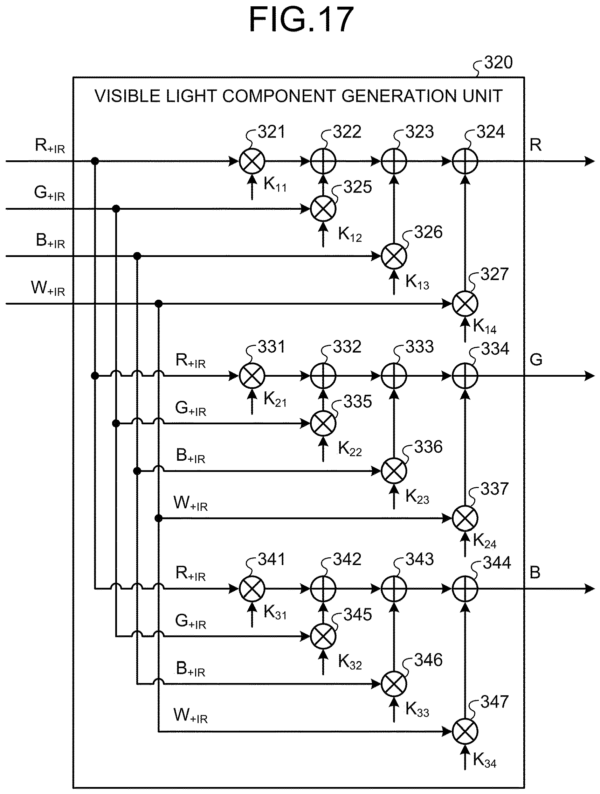

FIG. 17 is a functional block diagram of an example for describing functions of the visible light component generation unit 320 applicable to the second embodiment. The visible light component generation unit 320 includes multipliers 321, 325, 326, 327, 331, 335, 336, 337, 341, 345, 346, and 347, and adders 322, 323, 324, 332, 333, 334, 342, 343, and 344.

The multiplier 321 multiplies $R_{+IR}$ by the coefficient $K_{11}$, the multiplier 325 multiplies $G_{+IR}$ by the coefficient $K_{12}$, the multiplier 326 multiplies $B_{+IR}$ by the coefficient $K_{13}$, and the multiplier 327 multiplies $W_{+IR}$ by the coefficient $K_{14}$. The adders 322, 323, and 324 add the respective multiplication results of the multipliers 321, 325, 326, and 327, and supply, to the saturated pixel detection unit 350, the addition value as the data R indicating the value of the R color component.

The multiplier 331 multiplies $R_{+IR}$ by the coefficient $K_{21}$, the multiplier 335 multiplies $G_{+IR}$ by the coefficient $K_{22}$, the multiplier 336 multiplies $B_{+IR}$ by the coefficient $K_{23}$, and the multiplier 337 multiplies $W_{+IR}$ by the coefficient $K_{24}$. The adders 332, 333, and 334 add the respective multiplication results of the multipliers 331, 335, 336, and 337, and supply, to the saturated pixel detection unit 350, the addition value as the data G indicating the value of the G color component.

The multiplier 341 multiplies $R_{+IR}$ by the coefficient $K_{31}$, the multiplier 345 multiplies $G_{+IR}$ by the coefficient $K_{32}$, the multiplier 346 multiplies $B_{+IR}$ by the coefficient $K_{33}$, and the multiplier 347 multiplies $W_{+IR}$ by the coefficient $K_{34}$. The adders 342, 343, and 344 add the respective multiplication results of the multipliers 341, 345, 346, and 347, and supply, to the saturated pixel detection unit 350, the addition value as the data B indicating the value of the B color component.

An example of calculation formulas used by the IR separation processing unit 300 in the second embodiment are shown in the following Equations (12) and (13).

$$\begin{pmatrix} R \\ G \\ B \\ IR \end{pmatrix} = \begin{pmatrix} K_{11} & K_{12} & K_{13} & K_{12} \\ K_{21} & K_{22} & K_{23} & K_{24} \\ K_{31} & K_{32} & K_{33} & K_{34} \\ K_{41} & K_{42} & K_{43} & K_{44} \end{pmatrix} \begin{pmatrix} R_{+IR} \\ G_{+IR} \\ B_{+IR} \\ W_{+IR} \end{pmatrix} \qquad (12)$$

$$\begin{pmatrix} R \\ G \\ B \\ IR \end{pmatrix} = \begin{pmatrix} 0.5990275 & -0.45051 & -0.66262 & 0.582481 \\ -0.449838 & 0.595964 & -0.64036 & 0.605876 \\ -0.530649 & -0.4228 & -0.393077 & 0.617824 \\ 0.4202613 & 0.393446 & 0.569111 & -0.57222 \end{pmatrix} \begin{pmatrix} R_{+IR} \\ G_{+IR} \\ B_{+IR} \\ W_{+IR} \end{pmatrix} \qquad (13)$$

Equation (12) is an expression in which Equations (4) to (7) described above are expressed using a matrix. A vector including the respective data R, G, and B indicating the values of the R, G, and B color components and the data IR indicating the value of the infrared range component is calculated by a product of a vector including the data $R_{+IR}$, $G_{+IR}$, $B_{+IR}$, and $W_{+IR}$ and a matrix of 4 rows × 4 columns. Note that Equation (13) shows an example of coefficients set as $K_{11}$ to $K_{44}$ in Equation (12), respectively.

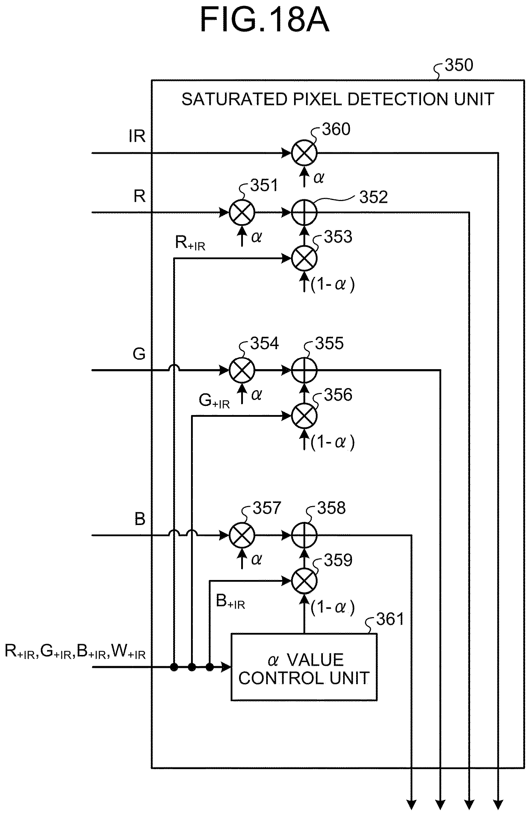

FIG. 18A is a functional block diagram of an example for describing functions of the saturated pixel detection unit 350 applicable to the second embodiment. The saturated pixel detection unit 350 includes multipliers 351, 353, 354, 356, 357, 359, and 360, adders 352, 355, and 358, and an α value control unit 361.

The α value control unit 361 controls the value of the coefficient α. The α value control unit 361 detects, for each pixel, whether or not the signal level of the pixel data is higher than the predetermined threshold value Th2. Then, in a case where the signal level is higher than the threshold value Th2, the α value control unit 361 sets, as the coefficient α, a smaller value of "0" or more and less than "1" for a higher signal level, and otherwise, sets "1" as the coefficient α. Then, the α value control unit 361 supplies the set coefficient α to the multipliers 351, 354, 357, and 360, and supplies a coefficient (1-α) to the multipliers 353, 356, and 359.

The multiplier 351 multiplies the data R indicating the value of the R color component by the coefficient α and supplies the multiplication result to the adder 352. The multiplier 353 multiplies the pixel data $R_{+IR}$ by the coefficient (1-α) and supplies the multiplication result to the adder 352. The adder 352 adds the multiplication results of the multipliers 351 and 353 and outputs the addition result as the data R from the IR separation processing unit 300.

The multiplier 354 multiplies the data G indicating the value of the G color component by the coefficient α and supplies the multiplication result to the adder 355. The multiplier 356 multiplies the pixel data $G_{+IR}$ by the coefficient (1-α) and supplies the multiplication result to the adder 355. The adder 355 adds the multiplication results of the multipliers 354 and 356 and outputs the addition result as the data G from the IR separation processing unit 300.

The multiplier 357 multiplies the data B indicating the value of the B color component by the coefficient α and supplies the multiplication result to the adder 358. The multiplier 359 multiplies the data $B_{+IR}$ by the coefficient (1-α) and supplies the multiplication result to the adder 358. The adder 358 adds the multiplication results of the multipliers 357 and 359 and outputs the addition result as the data B from the IR separation processing unit 300.

The multiplier 360 multiplies the data IR indicating the value of the infrared range component by the coefficient α and outputs the multiplication result from the IR separation processing unit 300.

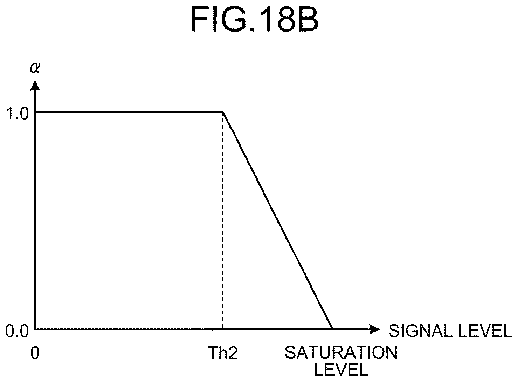

FIG. 18B is a schematic diagram illustrating an example of setting of the value of the coefficient α for each signal level applicable to the second embodiment. In FIG. 18B, a horizontal axis represents the signal level of the pixel data supplied from the false color suppression processing unit 1203'. A vertical axis represents the coefficient α. In a case where the signal level is equal to or lower than the threshold value Th2, for example, the coefficient α is set to a value of "1", and in a case where the signal level exceeds the threshold value Th2, the coefficient α is set to a smaller value for a higher signal level.

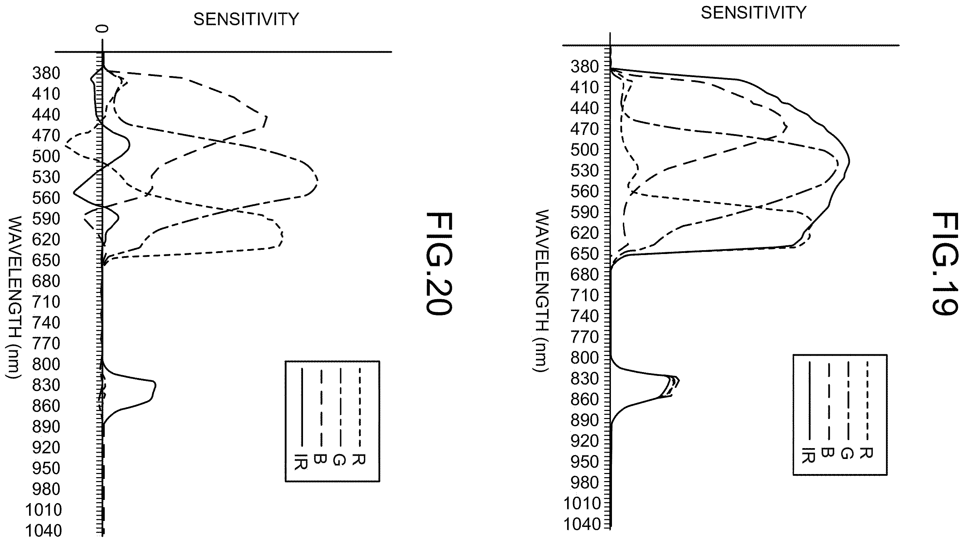

FIG. 19 is a schematic diagram illustrating an example of a sensitivity characteristic of each of the pixels R, G, B, and W applicable to the second embodiment. In FIG. 19, a horizontal axis represents the wavelength of light, and a vertical axis represents the sensitivity of the pixel to light having the corresponding wavelength. Further, a solid line indicates the sensitivity characteristic of the pixel W, and a fine dotted line indicates the sensitivity characteristic of the pixel R. In addition, a line with alternating long and short dashes indicates the sensitivity characteristic of the pixel G, and a coarse dotted line indicates the sensitivity characteristic of the pixel B.

The sensitivity of the pixel W shows a peak with respect to white (W) visible light. Furthermore, the sensitivities of the pixels R, G, and B show peaks with respect to red (R) visible light, green (G) visible light, and blue (B) visible light, respectively. The sensitivities of the pixels R, G, B, and W to the infrared light are substantially the same.

When red, green, and blue are additively mixed, the color becomes white. Therefore, the sum of the sensitivities of the pixels R, G, and B is a value close to the sensitivity of the pixel W. However, as illustrated in FIG. 19, the sum does not necessarily coincide with the sensitivity of the pixel W. In addition, although the sensitivities of the respective pixels to the infrared light are similar to each other, the sensitivities do not strictly coincide with each other.

For this reason, in a case where computation for obtaining a difference between a value obtained by performing weighted addition of the respective data $R_{+IR}$, $G_{+IR}$, and $B_{+IR}$ with the same coefficient "0.5" and a value obtained by performing weighted addition of the pixel data $W_{+IR}$ with the coefficient "0.5" is performed, the infrared range component is not accurately separated.

FIG. 20 is a schematic diagram illustrating an example of the sensitivity characteristics after infrared component separation according to the second embodiment. As illustrated in FIG. 20, the infrared range component (IR) generated by the weighted addition approaches "0" in the visible light range, and the error becomes smaller as compared with the comparative example illustrated in FIG. 19.

As described above, according to the second embodiment, since the weighted addition is performed on the data indicating the value of the component of each color with the coefficient at which the difference between the value obtained by performing weighted addition of the sensitivities of the pixels R, G, and B to the visible light and the value obtained by performing weighted addition of the sensitivity of the pixel W is reduced, the infrared light component can be accurately separated. As a result, the imaging device 1' according to the second embodiment can improve reproducibility of the color of the visible light and improve the image quality. In addition, it is possible to implement a day-night camera that does not require an IR insertion/removal mechanism.

[3. Third Embodiment]

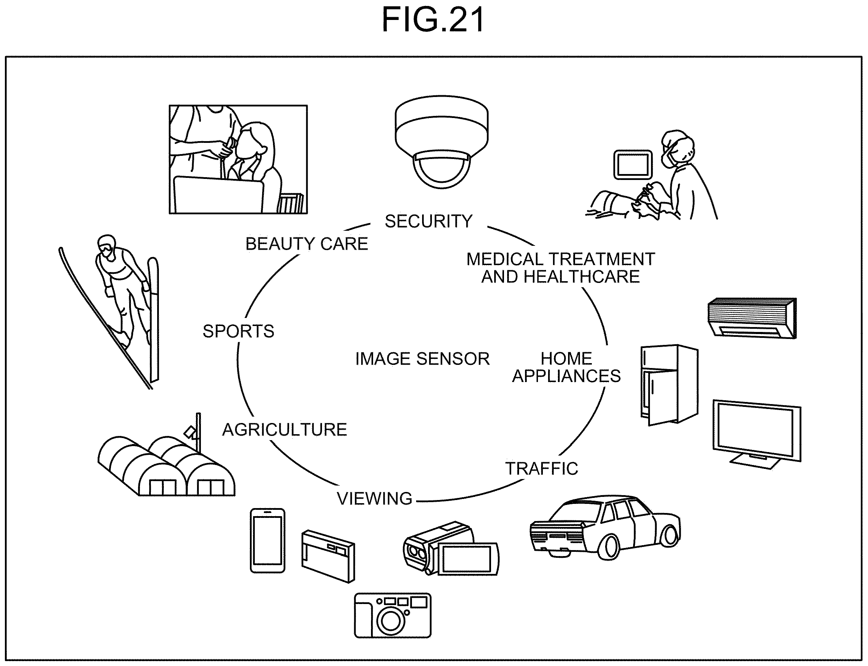

Next, a use example of the imaging device to which the technology according to the present disclosure is applied will be described. FIG. 21 is a diagram illustrating a use example of the imaging device 1 or the imaging device 1' according to the present disclosure described above. Hereinafter, for explanation, the imaging device 1 will be described as a representative of the imaging device 1 and the imaging device 1'.

The above-described imaging device 1 can be used, for example, in various cases of sensing light such as visible light, infrared light, ultraviolet light, and X-rays as described below.

· A device that captures an image provided for viewing, such as a digital camera and a portable device with an imaging function
· A device provided for traffic, such as an in-vehicle sensor for capturing an image of a region in front of, behind, surrounding, or inside a vehicle, a monitoring camera for monitoring a traveling vehicle or a road, or a distance measurement sensor for measuring a distance between vehicles, for the purpose of safe driving such as automatic stop and recognition of a driver's state
· A device provided for home appliances, such as a television (TV), a refrigerator, and an air conditioner, to capture an image of the gesture of the user and perform a device operation in accordance with the gesture
· A device provided for medical treatment and healthcare, such as an endoscope or a device for capturing an image of blood vessels by receiving infrared light
· A device provided for security, such as a monitoring camera for security or a camera for personal authentication
· A device provided for beauty care, such as a skin measuring device for capturing an image of skin or a microscope for capturing an image of scalp
· A device provided for sports, such as an action camera or a wearable camera for use in sports
· A device provided for agriculture, such as a camera for monitoring the state of fields and crops

(3-0. Example of Application to Moving Body)

The technology according to the present disclosure (the present technology) can be applied to various products described above. For example, the technology according to the present disclosure may be implemented as a device mounted in any one of moving bodies such as a vehicle, an electric vehicle, a hybrid electric vehicle, a motorcycle, a bicycle, a personal mobility device, a plane, a drone, a ship, and a robot.

(More Specific Example in Case Where Imaging Device of Present Disclosure is Mounted on Vehicle)

As an application example of the imaging device 1 according to the present disclosure, a more specific example in a case where the imaging device 1 is mounted on a vehicle and used will be described.

(First Mounting Example)

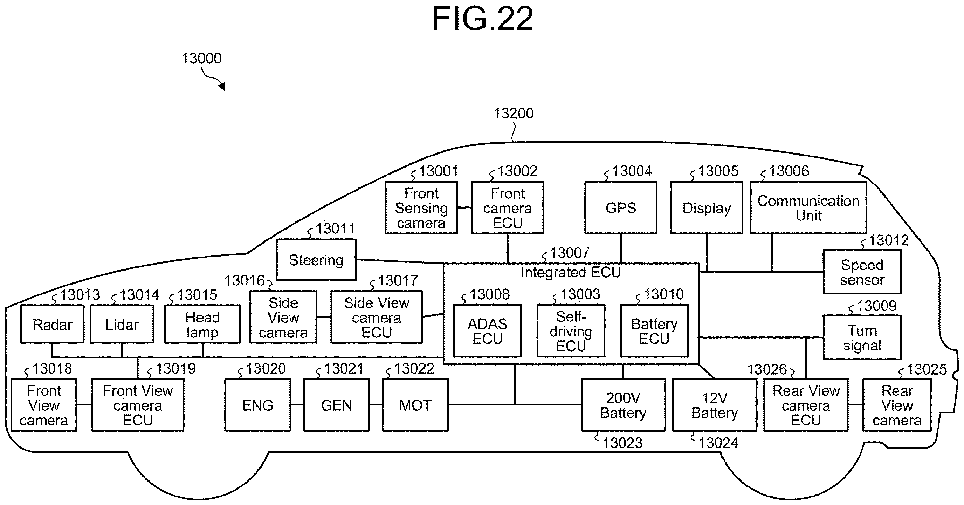

First, a first mounting example of the imaging device 1 according to the present disclosure will be described. FIG. 22 is a block diagram illustrating a system configuration example of a vehicle on which the imaging device 1 according to the present disclosure can be mounted. In FIG. 22, a vehicle system 13200 includes units connected to a controller area network (CAN) provided for a vehicle 13000.

A front sensing camera 13001 is a camera that captures an image of a front region in a vehicle traveling direction. In general, the camera is not used for image display, but is a camera specialized in sensing. The front sensing camera 13001 is arranged, for example, near a rearview mirror positioned on an inner side of a windshield.

A front camera ECU 13002 receives image data captured by the front sensing camera 13001, and performs image signal processing including image recognition processing such as image quality improvement and object detection. A result of the image recognition performed by the front camera ECU is transmitted through CAN communication.

Note that the ECU is an abbreviation for "electronic control unit".

A self-driving ECU 13003 is an ECU that controls automatic driving, and is implemented by, for example, a CPU, an ISP, a graphics processing unit (GPU), and the like. A result of image recognition performed by the GPU is transmitted to a server, and the server performs deep learning such as a deep neural network and returns a learning result to the self-driving ECU 13003.

A global positioning system (GPS) 13004 is a position information acquisition unit that receives GPS radio waves and obtains a current position. Position information acquired by the GPS 13004 is transmitted through CAN communication.

A display 13005 is a display device arranged in the vehicle 13000. The display 13005 is arranged at a central portion of an instrument panel of the vehicle 13000, inside the rearview mirror, or the like. The display 13005 may be configured integrally with a car navigation device mounted on the vehicle 13000.

A communication unit 13006 functions to perform data transmission and reception in vehicle-to-vehicle communication, pedestrian-to-vehicle communication, and road-to-vehicle communication. The communication unit 13006 also performs transmission and reception with the server. Various types of wireless communication can be applied to the communication unit 13006.

An integrated ECU 13007 is an integrated ECU in which various ECUs are integrated. In this example, the integrated ECU 13007 includes an ADAS ECU 13008, the self-driving ECU 13003, and a battery ECU 13010. The battery ECU 13010 controls a battery (a 200V battery 13023, a 12V battery 13024, or the like). The integrated ECU 13007 is arranged, for example, at a central portion of the vehicle 13000.

A turn signal 13009 is a direction indicator, and lighting thereof is controlled by the integrated ECU 13007.

The advanced driver assistance system (ADAS) 13008 generates a control signal for controlling components of the vehicle system 13200 according to a driver operation, an image recognition result, or the like. The ADAS ECU 13008 transmits and receives a signal to and from each unit through CAN communication.

In the vehicle system 13200, a drive source (an engine or a motor) is controlled by a powertrain ECU (not illustrated). The powertrain ECU controls the drive source according to the image recognition result during m cruise control.

A steering 13011 drives an electronic power steering motor according to the control signal generated by the ADAS ECU 13008 when the vehicle is about to deviate from a white line in image recognition.

A speed sensor 13012 detects a traveling speed of the vehicle 13000. The speed sensor 13012 calculates acceleration and differentiation (jerk) of the acceleration from the traveling speed. Acceleration information is used to calculate an estimated time before collision with an object. The jerk is an index that affects a ride comfort of an occupant.

A radar 13013 is a sensor that performs distance measurement by using electromagnetic waves having a long wavelength such as millimeter waves. A lidar 13014 is a sensor that performs distance measurement by using light.

A headlamp 13015 includes a lamp and a driving circuit of the lamp, and performs switching between a high beam and a low beam depending on the presence or absence of a headlight of an oncoming vehicle detected by image recognition. Alternatively, the headlamp 13015 emits a high beam so as to avoid an oncoming vehicle.

A side view camera 13016 is a camera arranged in a housing of a side mirror or near the side mirror. Image data output from the side view camera 13016 is used for m image display. The side view camera 13016 captures an image of, for example, a blind spot region of the driver. Further, the side view camera 13016 captures images used for left and right regions of an around view monitor.

A side view camera ECU 13017 performs signal processing on an image captured by the side view camera 13016. The side view camera ECU 13017 improves image quality such as white balance. Image data subjected to the signal processing by the side view camera ECU 13017 is transmitted through a cable different from the CAN.

A front view camera 13018 is a camera arranged near a front grille. Image data captured by the front view camera 13018 is used for image display. The front view camera 13018 captures an image of a blind spot region in front of the vehicle. In addition, the front view camera 13018 captures an image used in an upper region of the around view monitor. The front view camera 13018 is different from the front sensing camera 13001 described above in regard to a frame layout.

A front view camera ECU 13019 performs signal processing on an image captured by the front view camera 13018. The front view camera ECU 13019 improves image quality such as white balance. Image data subjected to the signal processing by the front view camera ECU 13019 is transmitted through a cable different from the CAN.

The vehicle system 13200 includes an engine (ENG) 13020, a generator (GEN) 13021, and a driving motor (MOT) 13022. The engine 13020, the generator 13021, and the driving motor 13022 are controlled by the powertrain ECU (not illustrated).

The 200V battery 13023 is a power source for driving and an air conditioner. The 12V battery 13024 is a power source other than the power source for driving and the air conditioner. The 12V battery 13024 supplies power to each camera and each ECU mounted on the vehicle 13000.

A rear view camera 13025 is, for example, a camera arranged near a license plate of a tailgate. Image data captured by the rear view camera 13025 is used for image display. The rear view camera 13025 captures an image of a blind spot region behind the vehicle. Further, the rear view camera 13025 captures an image used in a lower region of the around view monitor. The rear view camera 13025 is activated by, for example, moving a shift lever to "R (rearward)".

A rear view camera ECU 13026 performs signal processing on an image captured by the rear view camera 13025. The rear view camera ECU 13026 improves image quality such as white balance. Image data subjected to the signal processing by the rear view camera ECU 13026 is transmitted through a cable different from the CAN.

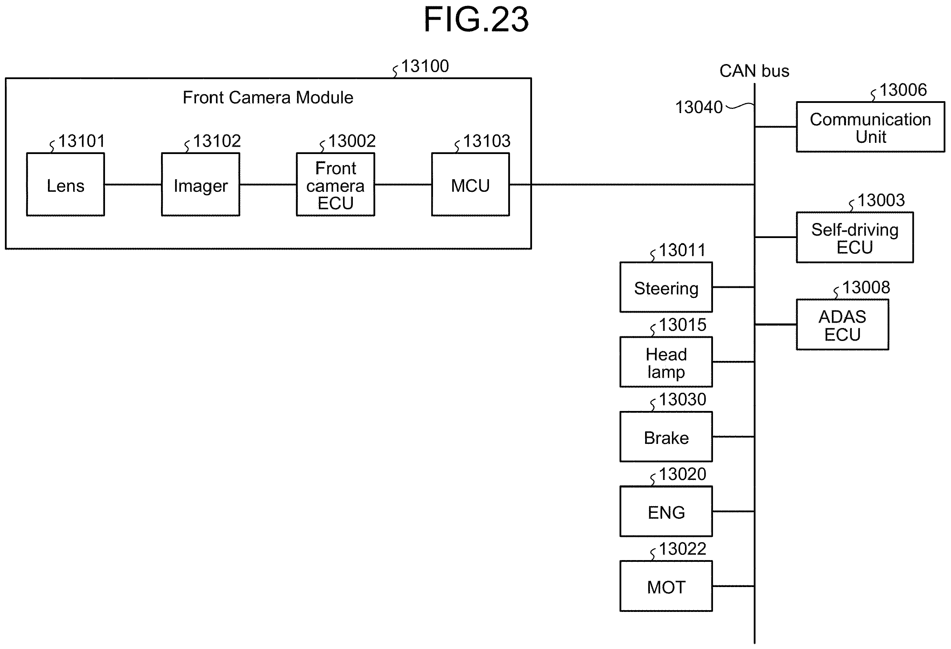

FIG. 23 is a block diagram illustrating a configuration of an example of the front sensing camera 13001 of the vehicle system 13200.

A front camera module 13100 includes a lens 13101, an imager 13102, a front camera ECU 13002, and a microcontroller unit (MCU) 13103. The lens 13101 and the imager 13102 are included in the front sensing camera 13001 described above. The front camera module 13100 is arranged, for example, near the rearview mirror positioned on the inner side of the windshield.

The imager 13102 can be implemented by using the imaging unit 10 according to the present disclosure, and captures a front region image by a light receiving element included in a pixel and outputs pixel data. For example, a pixel arrangement using a pixel block of $6 \times 6$ pixels as a unit described with reference to FIG. 6A is used as a color filter arrangement for the pixels. The front camera ECU 13002 includes, for example, the image processing unit 12, the output processing unit 13, and the control unit 14 according to the present disclosure. That is, the imaging device 1 according to the present disclosure includes the imager 13102 and the front camera ECU 13002.

Note that either serial transmission or parallel transmission may be applied to data transmission between the imager 13102 and the front camera ECU 13002. In addition, it is preferable that the imager 13102 has a function of detecting a failure of the imager 13102 itself.

The MCU 13103 has a function of an interface with a CAN bus 13104. Each unit (the self-driving ECU 13003, the communication unit 13006, the ADAS ECU 13008, the steering 13011, the headlamp 13015, the engine 13020, the driving motor 13022, or the like) illustrated in FIG. 22 is connected to the CAN bus 13104. A brake system 13030 is also connected to the CAN bus 13040.

As the front camera module 13100, the imaging unit 10 having the pixel arrangement using a pixel block of $6 \times 6$ pixels as a unit described with reference to FIG. 6A is used. Then, in the front camera module 13100, the image processing unit 12 performs the synchronization processing on each of the A series and the D series in the pixel arrangement in an independent manner. Furthermore, in the front camera module 13100, the image processing unit 12 performs the false color suppression processing on the basis of a result of the synchronization processing using the A series, a result of the synchronization processing using the D series, and a result of the synchronization processing using both the A series and the D series.

Therefore, the front camera module 13100 can output a captured image with higher image quality in which false colors corresponding to the frequencies fs/2 in the vertical and horizontal directions and the frequencies fs/4 in the vertical and horizontal directions are suppressed.

Note that, in the above description, it has been described that the imaging device 1 according to the present disclosure is applied to the front sensing camera 13001, but the present disclosure is not limited to thereto. For example, the imaging device 1 according to the present disclosure may be applied to the front view camera 13018, the side view camera 13016, and the rear view camera 13025.

(Second Mounting Example)

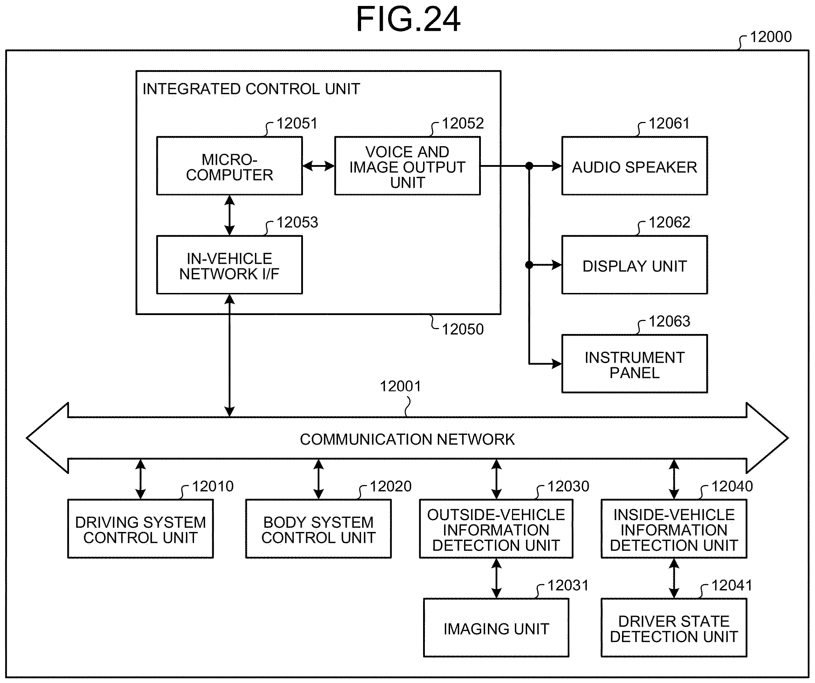

Next, a second mounting example of the imaging device 1 according to the present disclosure will be described. FIG. 24 is a block diagram illustrating an example of a schematic configuration of a vehicle control system which is an example of a moving body control system to which a technology according to the present disclosure can be applied.

A vehicle control system 12000 includes a plurality of electronic control units connected through a communication network 12001. In the example illustrated in FIG. 24, the vehicle control system 12000 includes a driving system control unit 12010, a body system control unit 12020, an outside-vehicle information detection unit 12030, an inside-vehicle information detection unit 12040, and an integrated control unit 12050. Furthermore, as a functional configuration of the integrated control unit 12050, a microcomputer 12051, a voice and image output unit 12052, and an in-vehicle network interface (I/F) 12053 are illustrated.

The driving system control unit 12010 controls an operation of a device related to a driving system of a vehicle according to various programs. For example, the driving system control unit 12010 functions as a control device such as a driving force generation device for generating a driving force of a vehicle such as an internal combustion engine, a driving motor, or the like, a driving force transmission mechanism for transmitting a driving force to vehicle wheels, a steering mechanism for adjusting a steering angle of the vehicle, a brake device for generating a braking force of the vehicle, or the like.

The body system control unit 12020 controls an operation of various devices mounted in a vehicle body according to various programs. For example, the body system control unit 12020 functions as a keyless entry system, a smart key system, a power window device, or a control device for various lamps such as a headlamp, a back lamp, a brake lamp, a blinker, a fog lamp, and the like. In this case, electric waves sent from a portable machine substituting for a key or a signal of various switches can be input to the body system control unit 12020. The body system control unit 12020 receives the electric waves or the signal to control a door-lock device of a vehicle, a power window device, a lamp, or the like.

The outside-vehicle information detection unit 12030 detects information regarding an outside area of a vehicle on which the vehicle control system 12000 is mounted. For example, an imaging unit 12031 is connected to the outside-vehicle information detection unit 12030. The outside-vehicle information detection unit 12030 causes the imaging unit 12031 to capture an image of an area outside the vehicle, and receives the captured image. The outside-vehicle information detection unit 12030 may perform processing of detecting an object such as a person, a car, an obstacle, a sign, a letter on a road surface, or the like, or perform distance detection processing on the basis of the received image.

The imaging unit 12031 is an optical sensor that receives light and outputs an electric signal corresponding to the amount of received light. The imaging unit 12031 can output the electric signal as an image, or can output the electric signal as distance measurement information. Furthermore, the light received by the imaging unit 12031 may be visible light or invisible light such as infrared rays or the like.

The inside-vehicle information detection unit 12040 detects information regarding an inside area of the vehicle. For example, a driver state detection unit 12041 detecting a state of a driver is connected to the inside-vehicle information detection unit 12040. The driver state detection unit 12041 includes, for example, a camera capturing an image of the driver, and the inside-vehicle information detection unit 12040 may calculate a degree of fatigue or a degree of concentration of the driver, or discriminate whether or not the driver is dozing off on the basis of detection information input from the driver state detection unit 12041.

The microcomputer 12051 can calculate a target control value of a driving force generation device, a steering mechanism, or a brake device on the basis of information regarding the inside area and the outside area of the vehicle, the information being acquired by the outside-vehicle information detection unit 12030 or the inside-vehicle information detection unit 12040, and can output a control instruction to the driving system control unit 12010. For example, the microcomputer 12051 can perform a cooperative control for the purpose of implementing functions of an advanced driver assistance system (ADAS) including vehicle collision avoidance, impact alleviation, following traveling based on an inter-vehicle distance, traveling while maintaining a vehicle speed, a vehicle collision warning, a vehicle lane departure warning, or the like.

Furthermore, the microcomputer 12051 can perform a cooperative control for the purpose of an automatic driving in which a vehicle autonomously travels without an operation by a driver by controlling a driving force generation device, a steering mechanism, a brake device, or the like on the basis of information regarding a surrounding area of the vehicle acquired by the outside-vehicle information detection unit 12030 or the inside-vehicle information detection unit 12040, or the like.

Furthermore, the microcomputer 12051 can output a control instruction to the body system control unit 12020 on the basis of outside-vehicle information acquired by the outside-vehicle information detection unit 12030. For example, the microcomputer 12051 can perform a cooperative control for the purpose of preventing glare by controlling a headlamp according to a position of a preceding vehicle or an oncoming vehicle detected by the outside-vehicle information detection unit 12030 to switch a high beam to a low beam, or the like.

The voice and image output unit 12052 transmits an output signal of at least one of voice or an image to an output device which is capable of visually or acoustically notifying a passenger of a vehicle or an outside area of the vehicle of information. In the example in FIG. 24, an audio speaker 12061, a display unit 12062, and an instrument panel 12063 are illustrated as the output devices. The display unit 12062 may include at least one of, for example, an on-board display or a head-up display.

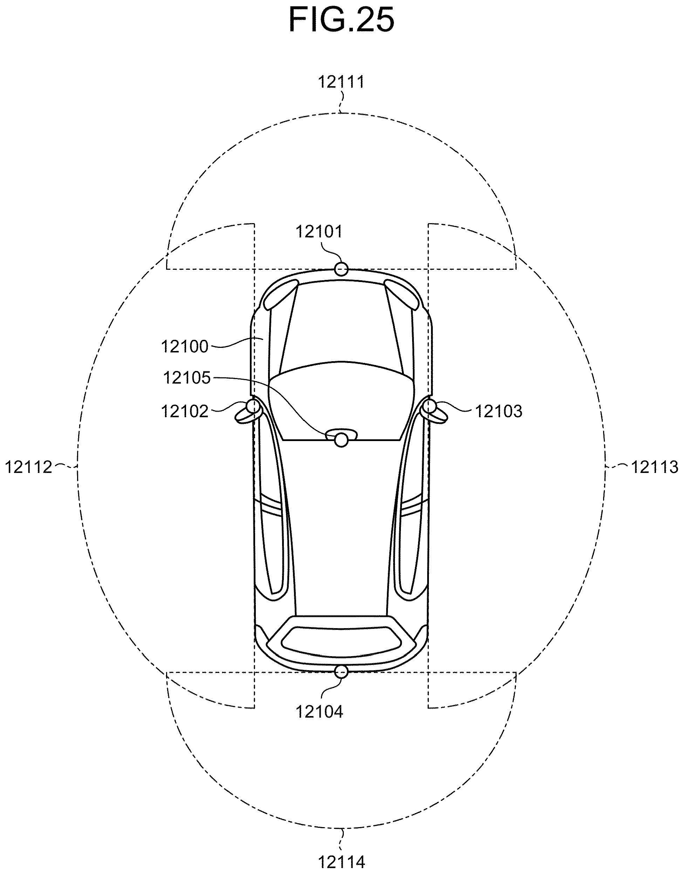

FIG. 25 is a diagram illustrating an example of an installation position of the imaging unit 12031.

In FIG. 25, a vehicle 12100 includes imaging units 12101, 12102, 12103, 12104, and 12105 as the imaging unit 12031.

The imaging units 12101, 12102, 12103, 12104, and 12105 are provided at, for example, a front nose, side mirrors, a rear bumper, a back door, an upper portion of a windshield in a compartment, and the like of the vehicle 12100. The imaging unit 12101 provided at the front nose and the imaging unit 12105 provided at the upper portion of the windshield in the compartment mainly acquire an image of an area in front of the vehicle 12100. The imaging units 12102 and 12103 provided at the side mirrors mainly acquire images of areas on sides of the vehicle 12100. The imaging unit 12104 provided at the rear bumper or the back door mainly acquires an image of an area behind the vehicle 12100. The images of the area in front of the vehicle 12100 acquired by the imaging units 12101 and 12105 are mainly used to detect a preceding vehicle, a pedestrian, an obstacle, a traffic light, a traffic sign, a lane, or the like.

Note that FIG. 25 illustrates an example of imaging ranges of the imaging units 12101 to 12104. An image capturing range 12111 indicates an image capturing range of the imaging unit 12101 provided at the front nose, image capturing ranges 12112 and 12113 indicate image capturing ranges of the imaging units 12102 and 12103 provided at the side mirrors, respectively, and an image capturing range 12114 indicates an image capturing range of the imaging unit 12104 provided at the rear bumper or the back door. For example, image data captured by the imaging units 12101 to 12104 are superimposed, thereby obtaining a bird's eye view image from above the vehicle 12100.

At least one of the imaging units 12101 to 12104 may have a function of acquiring distance information. For example, at least one of the imaging units 12101 to 12104 may be a stereo camera including a plurality of imaging elements, or may be an imaging element with pixels for phase difference detection.

For example, the microcomputer 12051 can extract a three-dimensional object traveling at a predetermined speed (for example, 0 km/h or higher) in substantially the same direction as that of the vehicle 12100, particularly, the closest three-dimensional object on a traveling path of the vehicle 12100, as a preceding vehicle, by calculating a distance to each three-dimensional object in the image capturing ranges 12111 to 12114, and a temporal change (a relative speed with respect to the vehicle 12100) in the distance on the basis of the distance information acquired from the imaging units 12101 to 12104. Moreover, the microcomputer 12051 can set an inter-vehicle distance to be secured in advance for a preceding vehicle, and can perform an automatic brake control (including a following stop control), an automatic acceleration control (including a following start control), and the like. As described above, a cooperative control for the purpose of an automatic driving in which a vehicle autonomously travels without an operation by a driver, or the like, can be performed.

For example, the microcomputer 12051 can classify and extract three-dimensional object data related to a three-dimensional object as a two-wheeled vehicle, an ordinary vehicle, a large vehicle, a pedestrian, and another three-dimensional object such as a power pole, on the basis of the distance information obtained from the imaging units 12101 to 12104, and use a result of the classification and extraction for automatic obstacle avoidance. For example, the microcomputer 12051 identifies an obstacle around the vehicle 12100 as an obstacle that is visible to the driver of the vehicle 12100 or an obstacle that is hardly visible. Then, the microcomputer 12051 determines a collision risk indicating a risk of collision with each obstacle, and in a case where the collision risk is equal to or higher than a set value and there is a possibility of collision, the microcomputer 12051 can output an alarm to the driver through the audio speaker 12061 or the display unit 12062 or perform forced deceleration or avoidance steering through the driving system control unit 12010 to perform driving assistance for collision avoidance.

At least one of the imaging units 12101 to 12104 may be an infrared camera that detects infrared rays. For example, the microcomputer 12051 can recognize a pedestrian by determining whether or not a pedestrian is present in captured images of the imaging units 12101 to 12104. Such a recognition of a pedestrian is performed through a procedure for extracting feature points in the captured images of the imaging units 12101 to 12104 that are, for example, infrared cameras, and a procedure for discriminating whether or not the object is a pedestrian by performing pattern matching processing on a series of feature points indicating an outline of the object. In a case where the microcomputer 12051 determines that a pedestrian is present in the captured images of the imaging units 12101 to 12104 and recognizes the pedestrian, the voice and image output unit 12052 controls the display unit 12062 to superimpose a rectangular contour line for emphasis on the recognized pedestrian. Furthermore, the voice and image output unit 12052 may control the display unit 12062 to display an icon or the like indicating a pedestrian at a desired position.

Hereinabove, an example of the vehicle control system to which the technology according to the present disclosure can be applied has been described. The technology according to the present disclosure can be applied to, for example, the imaging unit 12031 among the above-described configurations. Specifically, the imaging device 1 according to any one of the first and second embodiments of the present disclosure and the modified examples thereof can be applied as the imaging unit 12031. That is, the imaging unit 12031 includes, for example, a pixel array having the pixel arrangement using the pixel block of 6 × 6 pixels as a unit described with reference to FIG. 6A, and for example, the image processing unit 12, the output processing unit 13, and the control unit 14 according to the present disclosure.

Then, in the imaging unit 12031, the image processing unit 12 performs the synchronization processing on each of the A series and the D series in the pixel arrangement in an independent manner. Furthermore, in the imaging unit 12031, the image processing unit 12 performs the false color suppression processing on the basis of a result of the synchronization processing using the A series, a result of the synchronization processing using the D series, and a result of the synchronization processing using both the A series and the D series.

Therefore, the imaging unit 12031 can output a captured image with higher image quality in which false colors corresponding to the frequencies fs/2 in the vertical and horizontal directions and the frequencies fs/4 in the vertical and horizontal directions are suppressed.

Note that the effects described in the present specification are merely examples. The effects of the present disclosure are not limited thereto, and other effects may be obtained.

Note that the present technology can also have the following configurations.

(1) An imaging device comprising:

a pixel array that includes pixels arranged in a matrix arrangement, wherein
the pixel array includes
a plurality of pixel blocks each including 6 × 6 pixels,
the pixel block includes:

a first pixel on which a first optical filter that transmits light in a first wavelength range is provided;
a second pixel on which a second optical filter that transmits light in a second wavelength range is provided;
a third pixel on which a third optical filter that transmits light in a third wavelength range is provided; and
a fourth pixel on which a fourth optical filter that transmits light in a fourth wavelength range is provided,
the first pixels are alternately arranged in each of a row direction and a column direction of the arrangement,
one second pixel, one third pixel, and one fourth pixels are alternately arranged in each row and each column of the arrangement, and
the pixel block further includes
a line including at least one second pixel, one third pixel, and one fourth pixel in a first oblique direction that is parallel to a diagonal of the pixel block of the arrangement, and a line including at least one second pixel, one third pixel, and one fourth pixel in a second oblique direction that is parallel to a diagonal of the pixel block and is different from the first oblique direction.

(2) The imaging device according to the above (1), further comprising

a signal processing unit that performs signal processing on a pixel signal read from each of the pixels included in the pixel array, wherein
the signal processing unit
performs, in an independent manner, the signal processing on each of
the pixel signals read from a first pixel group including the second pixel, the third pixel, and the fourth pixel included in every other row and column selected from the arrangement among the second pixels, the third pixels, and the fourth pixels included in the pixel block, and
the pixel signals read from a second pixel group including the second pixel, the third pixel, and the fourth pixel different from those of the first pixel group.

(3) The imaging device according to the above (2), wherein

the signal processing unit
performs first synchronization processing on a basis of the pixel signals read from the second pixel, the third pixel, and the fourth pixel included in the first pixel group, and
performs, independently of the first synchronization processing, second synchronization processing on a basis of the pixel signals read from the second pixel, the third pixel, and the fourth pixel included in the second pixel group.

(4) The imaging device according to the above (3), wherein

the signal processing unit
further performs third synchronization processing on a basis of the pixel signals read from the second pixel, the third pixel, and the fourth pixel included in each of the first pixel group and the second pixel group, and
determines which of a processing result of the first synchronization processing, a processing result of the second synchronization processing, and a processing result of the third synchronization processing is to be output to a subsequent stage.

(5) The imaging device according to the above (4), wherein

the signal processing unit
performs, as the third synchronization processing, processing of obtaining an average value of the processing result of the first synchronization processing and the processing result of the second synchronization processing.

(6) The imaging device according to the above (4) or (5), wherein

the signal processing unit
selects, as the processing result to be output to the subsequent stage, a processing result corresponding to a smallest chrominance among a chrominance based on the processing result of the first synchronization processing, a chrominance based on the processing result of the second synchronization processing, and a chrominance based on the processing result of the third synchronization processing.

(7) The imaging device according to any one of the above (1) to (6), wherein

the first wavelength range is a wavelength range corresponding to an entire visible light range, and
the second wavelength range, the third wavelength range, and the fourth wavelength range are wavelength ranges corresponding to a red light range, a green light range, and a blue light range, respectively.

(8) The imaging device according to any one of the above (1) to (6), wherein

the first wavelength range is a wavelength range corresponding to a yellow range, and
the second wavelength range, the third wavelength range, and the fourth wavelength range are wavelength ranges corresponding to a red light range, a green light range, and a blue light range, respectively.

(9) The imaging device according to any one of the above (1) to (6), wherein

the first wavelength range is a wavelength range corresponding to an infrared range, and
the second wavelength range, the third wavelength range, and the fourth wavelength range are wavelength ranges corresponding to a red light range, a green light range, and a blue light range, respectively.

(10) The imaging device according to any one of the above (4) to (6), wherein

the first wavelength range is a wavelength range corresponding to an entire visible light range,
the second wavelength range, the third wavelength range, and the fourth wavelength range are wavelength ranges corresponding to a red light range, a green light range, and a blue light range, respectively, and
the signal processing unit
removes a component corresponding to an infrared range from the selected processing result on a basis of the processing result and the pixel signal read from the first pixel.

Reference Signs List

| 1, 1' | IMAGING DEVICE |
|---|---|
| 10 | IMAGING UNIT |
| 12, 12' | IMAGE PROCESSING UNIT |
| 13 | OUTPUT PROCESSING UNIT |
| 30 | DUAL BANDPASS FILTER |
| 120, 130, 131, 132, 133 | PIXEL BLOCK |
| 300 | IR SEPARATION PROCESSING UNIT |
| 310 | INFRARED LIGHT COMPONENT GENERATION UNIT |
| 320 | VISIBLE LIGHT COMPONENT GENERATION UNIT |
| 350 | SATURATED PIXEL DETECTION UNIT |
| 1201 | LOW-FREQUENCY COMPONENT SYNCHRONIZATION UNIT |
| 1202 | HIGH-FREQUENCY COMPONENT EXTRACTION UNIT |
| 1203, 1203' | FALSE COLOR SUPPRESSION PROCESSING UNIT |

1204                                    HIGH-FREQUENCY COMPONENT RESTORATION UNIT

**Claims**

1. An imaging device comprising:

   a pixel array that includes pixels arranged in a matrix arrangement, wherein
   the pixel array includes
   a plurality of pixel blocks each including 6 × 6 pixels,
   the pixel block includes:

   a first pixel on which a first optical filter that transmits light in a first wavelength range is provided;
   a second pixel on which a second optical filter that transmits light in a second wavelength range is provided;
   a third pixel on which a third optical filter that transmits light in a third wavelength range is provided; and
   a fourth pixel on which a fourth optical filter that transmits light in a fourth wavelength range is provided,
   the first pixels are alternately arranged in each of a row direction and a column direction of the arrangement,
   one second pixel, one third pixel, and one fourth pixels are alternately arranged in each row and each column of the arrangement, and
   the pixel block further includes
   a line including at least one second pixel, one third pixel, and one fourth pixel in a first oblique direction that is parallel to a diagonal of the pixel block of the arrangement, and a line including at least one second pixel, one third pixel, and one fourth pixel in a second oblique direction that is parallel to a diagonal of the pixel block and is different from the first oblique direction.

2. The imaging device according to claim 1, further comprising

   a signal processing unit that performs signal processing on a pixel signal read from each of the pixels included in the pixel array, wherein
   the signal processing unit
   performs, in an independent manner, the signal processing on each of
   the pixel signals read from a first pixel group including the second pixel, the third pixel, and the fourth pixel included in every other row and column selected from the arrangement among the second pixels, the third pixels, and the fourth pixels included in the pixel block, and
   the pixel signals read from a second pixel group including the second pixel, the third pixel, and the fourth pixel different from those of the first pixel group.

3. The imaging device according to claim 2, wherein

   the signal processing unit
   performs first synchronization processing on a basis of the pixel signals read from the second pixel, the third pixel, and the fourth pixel included in the first pixel group, and
   performs, independently of the first synchronization processing, second synchronization processing on a basis of the pixel signals read from the second pixel, the third pixel, and the fourth pixel included in the second pixel group.

4. The imaging device according to claim 3, wherein

   the signal processing unit
   further performs third synchronization processing on a basis of the pixel signals read from the second pixel, the third pixel, and the fourth pixel included in each of the first pixel group and the second pixel group, and
   determines which of a processing result of the first synchronization processing, a processing result of the second synchronization processing, and a processing result of the third synchronization processing is to be output to a subsequent stage.

5. The imaging device according to claim 4, wherein

   the signal processing unit

performs, as the third synchronization processing, processing of obtaining an average value of the processing result of the first synchronization processing and the processing result of the second synchronization processing.

6. The imaging device according to claim 4, wherein

the signal processing unit
selects, as the processing result to be output to the subsequent stage, a processing result corresponding to a smallest chrominance among a chrominance based on the processing result of the first synchronization processing, a chrominance based on the processing result of the second synchronization processing, and a chrominance based on the processing result of the third synchronization processing.

7. The imaging device according to claim 1, wherein

the first wavelength range is a wavelength range corresponding to an entire visible light range, and
the second wavelength range, the third wavelength range, and the fourth wavelength range are wavelength ranges corresponding to a red light range, a green light range, and a blue light range, respectively.

8. The imaging device according to claim 1, wherein

the first wavelength range is a wavelength range corresponding to a yellow range, and
the second wavelength range, the third wavelength range, and the fourth wavelength range are wavelength ranges corresponding to a red light range, a green light range, and a blue light range, respectively.

9. The imaging device according to claim 1, wherein

the first wavelength range is a wavelength range corresponding to an infrared range, and
the second wavelength range, the third wavelength range, and the fourth wavelength range are wavelength ranges corresponding to a red light range, a green light range, and a blue light range, respectively.

10. The imaging device according to claim 4, wherein

the first wavelength range is a wavelength range corresponding to an entire visible light range,
the second wavelength range, the third wavelength range, and the fourth wavelength range are wavelength ranges corresponding to a red light range, a green light range, and a blue light range, respectively, and
the signal processing unit
removes a component corresponding to an infrared range from the selected processing result on a basis of the processing result and the pixel signal read from the first pixel.

# FIG.1

1

IMAGING UNIT
10

IMAGE PROCESSING UNIT
12

OUTPUT PROCESSING UNIT
13

OUTPUT IMAGE

11

CONTROL UNIT
14

# FIG.2

# FIG.3

EP 4 036 617 A1

# FIG.4

120

# FIG.5

# FIG.6A

130

# FIG.6B

130

# FIG.7A

# FIG.7B

# FIG.8A

A SERIES

# FIG.8B

D SERIES

# FIG.9

# FIG.10

(a)

(b)

(c)

# FIG.11A

131

| R | Ye | G | Ye | B | Ye |
|---|----|---|----|---|-----|
| Ye | G | Ye | R | Ye | B |
| B | Ye | R | Ye | G | Ye |
| Ye | R | Ye | B | Ye | G |
| G | Ye | B | Ye | R | Ye |
| Ye | B | Ye | G | Ye | R |

# FIG.11B

132

| R | IR | G | IR | B | IR |
|---|----|---|----|---|-----|
| IR | G | IR | R | IR | B |
| B | IR | R | IR | G | IR |
| IR | R | IR | B | IR | G |
| G | IR | B | IR | R | IR |
| IR | B | IR | G | IR | R |

# FIG.11C

133

# FIG.12

# FIG.13

# FIG.14

# FIG.15

R$_{+IR}$,G$_{+IR}$,B$_{+IR}$,W$_{+IR}$

⌒300

IR SEPARATION PROCESSING UNIT

⌒310

INFRARED
LIGHT
COMPONENT
GENERATION
UNIT

IR

⌒350

SATURATED
PIXEL
DETECTION
UNIT

⌒320

VISIBLE LIGHT
COMPONENT
GENERATION
UNIT

R,G,B

R$_{+IR}$,G$_{+IR}$,B$_{+IR}$,W$_{+IR}$

R,G,B      IR

# FIG.16

# FIG.17

# FIG.18A

# FIG.18B

## FIG.19

## FIG.20

FIG.21

MEDICAL TREATMENT
AND HEALTHCARE

SECURITY

HOME
APPLIANCES

BEAUTY CARE

IMAGE SENSOR

TRAFFIC

SPORTS

AGRICULTURE

VIEWING

# FIG.22

13000

13200

- 13001 Front Sensing camera
- 13002 Front camera ECU
- 13004 GPS
- 13005 Display
- 13006 Communication Unit
- 13011 Steering
- 13007 Integrated ECU
- 13012 Speed sensor
- 13016 Side View camera
- 13017 Side View camera ECU
- 13008 ADAS ECU
- 13003 Self-driving ECU
- 13010 Battery ECU
- 13009 Turn signal
- 13013 Radar
- 13014 Lidar
- 13015 Head lamp
- 13018 Front View camera
- 13019 Front View camera ECU
- 13020 ENG
- 13021 GEN
- 13022 MOT
- 13023 200V Battery
- 13024 12V Battery
- 13026 Rear View camera ECU
- 13025 Rear View camera

EP 4 036 617 A1

# FIG.23

Front Camera Module — 13100

Lens — 13101

Imager — 13102

Front camera ECU — 13002

MCU — 13103

CAN bus

13040

Communication Unit — 13006

Self-driving ECU — 13003

ADAS ECU — 13008

Steering — 13011

Head lamp — 13015

Brake — 13030

ENG — 13020

MOT — 13022

EP 4 036 617 A1

# FIG.24

EP 4 036 617 A1

# FIG.25

## INTERNATIONAL SEARCH REPORT

| International application No. |
| --- |
| PCT/JP2020/035144 |

### A. CLASSIFICATION OF SUBJECT MATTER
Int.Cl. G02B5/20(2006.01)i, H01L27/146(2006.01)i, H04N9/07(2006.01)i
FI: H04N9/07A, H01L27/146D, G02B5/20101

According to International Patent Classification (IPC) or to both national classification and IPC

### B. FIELDS SEARCHED
Minimum documentation searched (classification system followed by classification symbols)
Int.Cl. G02B5/20, H01L27/146, H04N9/07

Documentation searched other than minimum documentation to the extent that such documents are included in the fields searched
Published examined utility model applications of Japan     1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | WO 2013/145487 A1 (SONY CORPORATION) 03 October 2013 (2013-10-03), fig. 2 | 1-10 |
| A | JP 2016-25626 A (SONY CORPORATION) 08 February 2016 (2016-02-08), fig. 10 | 1-10 |
| A | JP 2016-511562 A (SAMSUNG ELECTRONICS CO., LTD.) 14 April 2016 (2016-04-14), fig. 12B, 14 | 1-10 |

☐ Further documents are listed in the continuation of Box C.     ☒ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 19 October 2020 | 27 October 2020 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
| --- | --- |

Form PCT/ISA/210 (second sheet) (January 2015)

**INTERNATIONAL SEARCH REPORT**
Information on patent family members

International application No.

PCT/JP2020/035144

| | | | |
|---|---|---|---|
| WO 2013/145487 A1 | 03 October 2013 | US 2015/0029358 A1<br>fig. 2<br>US 2017/0251188 A1<br>EP 2833635 A1 | |
| JP 2016-25626 A | 08 February 2016 | (Family: none) | |
| JP 2016-511562 A | 14 April 2016 | US 2014/0204183 A1<br>fig. 12B, 14<br>WO 2014/115984 A1<br>EP 2757790 A1 | |

Form PCT/ISA/210 (patent family annex) (January 2015)

**REFERENCES CITED IN THE DESCRIPTION**

**Patent documents cited in the description**

- WO 13145487 A
- JP 6530751 B